# EUROPEAN PATENT SPECIFICATION

(11) **EP 4 136 707 B1**
(45) Date of publication and mention of the grant of the patent: **28.05.2025**
(21) Application number: 21717466.3
(22) Date of filing: 14.04.2021
(51) Int. Cl.: H01Q 1/42, G01R 1/04, G01N 22/00, G01R 27/26, G01R 29/08

(54) **DEVICES, SYSTEMS AND METHODS FOR MEASURING RADOMES**
VORRICHTUNGEN, SYSTEME UND VERFAHREN ZUR MESSUNG VON RADOMEN
DISPOSITIFS, SYSTÈMES ET PROCÉDÉS DE MESURE DE RADÔMES

(30) Priority: 15.04.2020 EP 20169659
(43) Date of publication of application: 22.02.2023
(73) Proprietor: Perisens GmbH, 85622 Feldkirchen (DE)
(72) Inventor: STÜLZEBACH, Hannes, 84571 Arbing (DE); PFEIFFER, Florian, 81825 München (DE)
(74) Representative: Stellbrink & Partner Patentanwälte mbB
(86) International application number: PCT/EP2021/059680
(87) International publication number: WO 2021/209508

(56) References cited:
- EP-A1- 3 258 288
- FR-A1- 2 661 249
- US-A- 5 371 505
- US-A1- 2003 117 268
- US-A1- 2018 306 903

## Description

### Field of invention

The present invention generally relates devises, systems and methods for testing radomes.

### Introduction

Radars are detection system or sensors that use electromagnetic waves to determine range, angle or velocity of objects. A radar usually consists of a transmitting unit, or antenna, that radiates electromagnetic waves. The frequency of the emitted electromagnetic wave, or the operational frequency of the radar, can be within a wide range of the electromagnetic spectrum, usually within the radio and microwave part of the spectrum and depends on the use scenario of the radar. The lower the operational frequency of the radar the higher the detection range, as the transmitted electromagnetic waves are less attenuated or affected by external factors, e.g. by weather conditions, radar covers, etc. On the other hand, high frequencies offer a better accuracy and resolution of detection due to the smaller wavelength, but at the same time are highly susceptible to attenuation.

An emerging technology is the use of radar systems in automotive industry. More particularly, radars operating in high frequencies, such as, 20 to 300 GHz, usually between 70 and 90 GHz, can provide a very high range resolution and achievable accuracy. This feature makes such radars preferable for use in parking assistants, blind spot monitoring, brake assistant systems, etc. However, due to the very high operating frequency, such radar systems suffer from high signal attenuation.

A radar is usually set to operate in open-air conditions. Thus, the radar is exposed to different weather conditions, dust or other external particles and forces that may damage the radar and/or lower the accuracy of its measurements. When used in vehicles, the radars are typically covered for esthetic reasons so that they are not visible. To cope with this, a radome, also referred as a radar dome or radar cover, is implemented around the radar, hence protecting it against external factors and/or for hiding it.

However, the radome may negatively influence the operation of the radar. Due to dielectric characteristics of the radome material, the radome may cause unwanted reflections, attenuation, beam deflection, beam broadening, sidelobe increase, etc. These side effects may introduce errors in the radar sensing. The unwanted effects caused by the radome, particularly attenuation of the radar signal, can become significant when the radar operates in high frequencies. For example, the radars operating in high frequencies, usually used in automotive industry, are highly susceptible to suffer from attenuation and other unwanted effects caused by the radome.

Thus, in one hand it is advantageous for various reasons (e.g. protection against weather conditions or external elements or forces and/or improving vehicle design) to cover the radar sensor with a radome, while on the other hand the radome introduces many unwanted effects (e.g. signal attenuation) that may increase the inaccuracy or decrease the detection or sensing capability of the radar.

Furthermore, the use of radar-based systems in vehicles, such as parking assistance systems, blind spot monitoring systems, braking assistance systems, etc., are prone to strict requirements set by legal standards, such that maximum safety can be ensured for traffic participants. These standards or regulations usually require high detection accuracy.

Some attempts that tackle this issue are already present in the state of the art. They are mostly based on measurements with radar sensors, wherein radar test targets, usually reflectors, are positioned within a certain distance from the radar sensor and the reflection power is measured, with and without a radome. The difference between the two power values is used to quantify the attenuation caused by the radome.

For example, US 5,371,505A discloses a method for determining signal transmission characteristics for a selected area of a radome the method comprising the steps of radiating a test signal toward said selected area of said radome, reflecting said test signal from a predetermined first reflection position, after said test signal has passed through said selected area of said radome, to provide a reflected test signal, receiving said reflected test signal, storing data representative of said reflected test signal, repeating the above steps with said predetermined first reflection position changed to a predetermined second reflection position and processing said stored data to provide data representative of signal transmission characteristics for said selected area of said radome.

US 3,936,736A discloses a handheld universal radome tester which is an instrument for locating discontinuities and impurities inside a radome wall and for determining the quality of an anti-static paint coating over the exterior surface of a radome. It includes a microwave segment which is energized in the discontinuities/impurities mode of operation to measure energy reflected by the radome wall, and a dc segment which is energized in the anti-static paint tester mode to measure resistance in megohms per square. The tester is battery-operated making it a completely portable device.

The above-mentioned publications, as discussed, are based on indirect measurements via reflection measurement. However, reflection-based measurements of the radome dielectric properties may introduce measurement errors.

Furthermore, the radar covers (i.e. radomes) can comprise different shapes. For example, in the vehicle industry radars can be hidden behind bumpers, emblems, front grille, front panels (instead of grills, particularly, in electric cars) and the like. As such, the measuring device need to be able to measure radomes, irrespective of their shapes.

An example of a known measuring device used to characterize radomes is found in FR 2 661 249 A1 which discloses a system for establishing the radio permeability of a radome for an aircraft. The electromagnetic equipment provided comprises a microwave transmitter and a receiver arranged to cooperate with each other in the near-field region; the wall of the radome is placed between the transmitter and receiver so that the receiver receives a wave which has been attenuated by passing through the wall; the attenuation of the wave is measured successively in itemised elementary regions of the wall so that the whole of its working surface is scanned. The emitter is mounted on an adjustable telescopic stand inside the radome and the receiver is mounted on a similar adjustable stand outside the radome, whereby the distance between the emitter and the receiver is adjusted by the telescopic stand.

Moreover, typically the radome measuring process can be part of the process producing the radomes. As such, it the measuring device need to be easily integrable with other devices and/or processes (e.g. production lines).

At least some of these objects are met by the present invention.

### Summary

The invention is defined by the radome measuring clamp according to claim 1 and the method of measuring the effects of a radome on electromagnetic waves traversing through the radome according to claim 14. Further aspects are defined by the corresponding dependent claims.

In a first aspect, the present invention relates to a radome measuring clamp configured to perform a radome measurement. The radome measuring clamp comprises a base frame, a first arm attached to the base frame, two antenna heads, each configured for attaching at least one antenna therein.

The radome measuring clamp comprises an arm extension. The arm extension is configured to facilitate extending the length of the first arm. This further increases the adaptability of the radome measuring clamp to particular radomes (e.g. radome shapes, radome sizes) and/or to particular environments (e.g. to the free space available for accessing a radome). The arm extension is configured to be releasably attached with the first arm and with one of the at least two antenna heads.

A radome, or radar dome, is a structural enclosure implemented around a radar sensor (or radar) for protecting the radar. The radome can be weatherproof, thus, protecting the radar sensor from humidity, temperature, dust, etc. While in some cases the radome can be built specifically for protecting the radar, in other cases the radar can be hidden behind a structure, which can play the role of the radome. For example, in cars or robots, the radars can be hidden inside the enclosures of the car or robot (e.g. hidden behind the bumpers of the car) for esthetic reasons or for protecting the radars. The enclosure would act as a radome, hiding the radar sensor and protecting it from external factors, such as, weather.

However, as the radome interrupts the path of the signals transmitted and received by the radar sensor, the radome may affect these signals and as a consequence may lower the sensitivity and accuracy of the radar sensing. For example, the radome may cause attenuation, phase shift, reflection, refraction, scattering etc., of the electromagnetic waves that pass through it.

Thus, in one hand it can be advantageous to use the radome for protecting the radar and/or esthetic reasons, while on the other hand the radome interferes with the sensing of the radar. In this first aspect the current invention, addresses this issue by providing a radome measuring clamp configured to perform a radome measurement.

The radome measurement can comprise measuring electromagnetic, transmission and/or reflection properties of a radome, radome material or radome sample. For example, during a radome measurement the following effects caused by the radome on the antenna (or radar or sensor) it is covering, can be measured and/or inferred: attenuation of an electromagnetic wave traversing through the radome, phase shift caused when the electromagnetic wave traverses through the radome, reflection of electromagnetic waves hitting the radome, deflection of the main beam of the antenna, increasing of the beam width of the antenna, extension of sidelobes of the antenna or any combination thereof. Alternatively or additionally, during a radome measurement the scattering parameters, or S-parameters, can be measured and/or calculated and/or inferred.

The information gained by measuring the effect that the radome can have on the electromagnetic waves traversing through it, can be used to compensate for the effect of the radome during radar sensing. Hence, the sensing and accuracy of the radar covered by the radome can be improved.

Further, the radome measuring clamp can also provide a manner of testing radomes if they meet preset requirements. For example, the radome measuring clamp can measure the attenuation of a signal on a certain frequency range, caused by the radome and can determine if the radome meets a preset requirement stating the maximum tolerable attenuation that the radome can cause to electromagnetic waves.

This can be particularly advantageous on radars used in cars, i.e. automotive radars. In one hand, the automotive radars operate in high frequency ranges, such as, 70 - 90 GHz. Thus, the influence of the radome in this high frequency signals can be significant. On the other hand, strict requirements may be imposed by respective authorities, on the accuracy that automotive radar sensors should comprise, to ensure safety of traffic participants. Thus, testing radomes and their effect can be advantageous, to prove (or disprove) that, a radome or a radar system meets the preset requirements.

The clamp structure, i.e. comprising a substantially U-like shape, of the radome measuring clamp can be particularly advantageous. Firstly, it can facilitate providing two antennas facing each other. Secondly, it can facilitate providing the two antennas on two different sides of a radome, by positioning the radome within the clamp. Moreover, as two antennas can be provided on different sides of a radome, a signal can be transmitted between the antennas and through the radome. Thus, a direct measurement of the effect of the radome can be performed, instead of performing an indirect measurement via reflection measurement, as is common in the art.

Additionally, the clamp structure can facilitate providing a distance between two antennas while they face each other. Furthermore, the clamp structure can facilitate keeping such a distant constant, at least during a radome measurement. Additionally still, the clamp structure facilitate handling (i.e. moving) the antennas without changing the alignment between them.

All in all, the clamp structure allows for the radome measuring clamp to be a compact device. This facilitates the handling the radome measuring clamp, and particularly positioning the radome measuring clamp such that a radome is positioned between the two antennas. As such, the radome measuring clamp can measure radomes of different shapes and irregular shapes such as, e.g., car bumps acting as radomes. Moreover, having a compact structure, facilitates integrating the radome measuring clamp in production lines, wherein typically space is limited.

In some embodiments, the radome measuring clamp can comprise a modular structure. The modular structure of the radome measuring clamp can be provided by releasably attaching the components of the radome measuring clamp.

Throughout the text, a releasable attachment refers to any attachment between a first component and a second component that is configured to facilitate coupling and uncoupling the first component and the second component. That is, the releasable attachment allows for the first component to be coupled to the second component and after that it allows uncoupling of the first component from the second component. Moreover, the releasable attachment between the first component and the second component is configured to hold the first component and the second component firmly attached to each other while the connection between the two is maintained. For example, the releasable attachment can be based on a key-and-lock principle, plug-and-socket principle, screw-and-thread principle or any combination thereof. It will be understood that the above are only some exemplary and non-limiting releasable attachments.

The modularity of the radome measuring clamp can be advantageous for multiple reasons. As an initial matter, it greatly facilitates the manufacturing process, and particularly the manufacture milling process of the radome measuring clamp. Instead of manufacturing the radome measuring clamp as a single structure, smaller and more manageable structures can be manufactures instead.

Furthermore, modularity of the radome measuring clamp can facilitate rendering the radome measuring clamp into different configurations with different shapes. For example, the radome measuring clamp can comprise a dual-arm structure or a single-arm structure, as will be discussed further below. Thus, modularity of the radome measuring clamp can facilitate adjusting the radome measuring clamp to particular radomes (e.g. radome shapes, radome sizes) and/or to particular environments (e.g. to the free space available for accessing a radome). This further makes it easier to integrate the radome measuring clamp into existing processes, e.g., production lines of the radomes. In other words, the modularity of the radome measuring clamp can increase the versatility of systems and processes wherein the radome measuring clamp can be used.

Moreover, modularity of the radome measuring clamp facilitates repairing the radome measuring clamp. More particularly, due to modularity, a damage of the radome measuring clamp can be more localized. Thus, in one hand it can be easier to locate a defect (i.e. by locating the damaged component) and on the other hand the radome measuring clamp can be easily fixed by replacing the damaged component. Furthermore, this can also alleviate the need of an expert user for repairing the radome measuring clamp. That is, repairing the radome measuring clamp can simply consist of replacing one of the components, which can be a routine process of using a radome measuring clamp - hence any user trained to use the radome measuring clamp can perform a repair. This can be particularly advantageous as it can reduce the downtime of the radome measuring clamp, hence contributing on increasing the overall efficiency of the radome measuring clamp.

In the following, releasable attachments that can be comprised by embodiments of the radome measuring clamp will be discussed.

The base frame and the first arm can be configured to be releasably attached to each other. Thus, modularity can be provided between the base frame and the first arm.

The first arm can be attached to the base frame such that the first arm is in a substantial vertical position with respect to the base frame. That is, the base frame typically lies or extends in a horizontal position. In other words, the largest dimension of the base frame defines a horizontal plane. The first arm extends substantially perpendicular to the horizontal plane (i.e. to the base frame). That is, the first arm extends in a substantially vertical direction. In other words, the length of the first arm defines a vertical direction or position. These definitions are valid throughout the text.

The base frame can comprise at least one base-arm mounting interface configured to facilitate releasably attaching the first arm to the base frame.

The first arm can comprise at least one arm-base mounting interface configured to facilitate releasably attaching the first arm to the base frame.

The base-arm mounting interface and the arm-base mounting interface can be compatible.

The interface between the first arm and the base frame can be standard - i.e. any arm and any base frame comprises the same respective interface. As such, any arm comprising the base-arm mounting interface can be mounted on a base frame comprising the base-arm mounting interface and vice versa.

The first arm can be configured for releasably attaching at least one of the two antenna heads therein. Thus, modularity can also be provided between the antenna heads and the first arm.

The first arm can comprise at least one antenna head mounting interface, each configured to facilitate releasably attaching one antenna head to the first arm.

In some embodiments, the first arm can comprise a first antenna head mounting interface configured to facilitate releasably attaching one antenna head therein, such that the antenna head can extend lengthwise substantially parallel to the first arm. That is, the first antenna head mounting interface can allow the antenna head to be mounted in a substantially vertical position with respect to the base frame.

In some embodiments, the first arm can comprise a second antenna head mounting interface configured to facilitate releasably attaching one antenna head therein, such that the antenna head can extend lengthwise substantially perpendicular to the first arm. That is, the second antenna head mounting interface can allow the antenna head to be mounted in a substantially horizontal position with respect to the base frame.

In some embodiments, the first arm can comprise a third antenna head mounting interface configured to facilitate releasably attaching one antenna head therein, such that the antenna head can extend lengthwise substantially perpendicular to the first arm. That is, the third antenna head mounting interface can allow the antenna head to be mounted in a substantially horizontal position with respect to the base frame.

The second antenna head mounting interface and the third antenna head mounting interface can be provided at different distances from the base frame.

Each of the two antenna heads can be configured to be releasably attached to the first arm.

In some embodiments, each of the two antenna heads can comprise at least one arm mounting interface configured to facilitate releasably attaching the antenna head to the first arm.

The antenna head mounting interface and the arm mounting interface can be compatible. The interface between the first arm and the antenna head can be standard - i.e. any arm and any antenna head can comprise the same respective interface. As such, any antenna head comprising the arm mounting interface can be mounted to any arm comprising the antenna head mounting interface and vice versa.

The arm extension can be configured to be releasably attached with the first arm and with one of the at least two antenna heads. Furthermore, the arm extension can be configured to be releasably attached between the first arm and the one of the at least two antenna heads for increasing a distance between the first arm and the one of the at least two antenna heads. This can facilitate providing the antenna heads away from the body of the radome measuring clamp and particularly away from the base frame. This can be particularly advantageous for measuring central potions of large radomes.

The arm extension can be further configured such that two arm extensions can be releasably attachable with each other. That is, the arm extensions can be linked in series. In one hand this can facilitate further increasing the distance between the first arm and the one of the at least two antenna heads. On the other hand, it can allow for the arms to be extended in steps.

In some embodiments, at least one further arm extension can be configured to be releasably attached between first arm and the arm extension for further increasing the distance between the first arm and the one of the at least two antenna heads.

Similarly, at least one further arm extension can be configured to be releasably attached between the one of the at least two antenna heads and the arm extension for further increasing the distance between the first arm and the one of the at least two antenna heads.

In some embodiments, the arm extension can comprise at least one antenna head mounting interface and at least one arm mounting interface. As such, the arm extension can be mounted on the antenna head mounting interface of the first arm utilizing the arm mounting interface of the arm extension. It can further provide an antenna head mounting interface. In other words, the arm extension can be mounted on either the first arm or the antenna head and can provide the interface that it blocks.

In a preferred embodiment, the radome measuring clamp can comprise a second arm.

The second arm can be identical to the first arm. More particularly, the first arm and the second arm can be identical in that they can comprise a similar or identical shape and structure. That is, the radome measuring clamp can comprise two identical arms, each arm comprising any of the features discussed above for the first arm. The two arms can facilitate creating the clamp structure of the radome measuring clamp. That is, in some embodiments, the clamp structure of the radome measuring clamp can be implemented by providing two arms releasably attached to the base, with the two arms at a distance from each other.

In such embodiments, the base frame and the second arm can be configured to be releasably attached to each other. The attachment between the base frame and the second arm can be identical to the attachment between the base frame and the second arm. However, it will be understood that the first arm and the second arm can be attached on different positions of the base. For example, the first arm and the second arm can be attached on opposite lateral faces of the base frame.

That is, in such embodiments, the base frame can comprise at least two base-arm mounting interfaces, each configured to facilitate releasably attaching any of the first arm and the second arm to the base frame.

The first arm and the second arm can protrude along the same direction from the base frame.

The first arm and the second arm can mirror symmetric. That is, the first arm and the second arm can be symmetric to each other with respect to a vertical plane positioned equidistantly from them.

The first arm and the second arm can extend lengthwise substantially perpendicular to the base frame. That is, the first arm and the second arm can be substantially vertical with respect to the base frame.

The first arm and the second arm can comprise a substantially straight lengthwise extension. That is, the length of the first arm and the second arm at any point in the same vertical cross section can be a linear function of the distance from the base frame.

In some embodiments the first arm and the second arm can be curved. That is, the length of the first arm and the second arm at any point in the same vertical cross section can be a non-linear function of the distance from the base frame.

In general, the first arm and the second arm can comprise a custom shape. That is, the shape of the first arm and the second arm can be customized for a particular environment and/or process wherein the radome measuring clamp is intended to be used.

The first arm and the second arm can be longitudinal in the direction of protrusion.

Each of the antenna heads can be configured to be releasably attached on a respective one of the first arm and second arm. This can facilitate positioning the first and the second antenna to face each other.

In some embodiments, each of the antenna heads can be configured to be releasably attached on a respective one of the first antenna head mounting interface of the first arm and the first antenna head mounting interface of the second arm. Thus, both of the antenna heads extend lengthwise substantially parallel to the first arm and to the second arm, i.e., both antenna heads are in a substantially vertical position with respect to the base frame.

The radome measuring clamp can comprise a respective arm extension for the first arm and the second arm.

Each arm extension can be configured to be releasably attached on a respective one of the first antenna head mounting interface of the first arm and the first antenna head mounting interface of the second arm, such that the two arm extensions can extend lengthwise substantially parallel to the first arm and to the second arm, respectively.

Each of the antenna heads can be configured to be releasably attached on a respective one of the arm extensions, such that each arm extension can be positioned between the respective antenna head and the respective first antenna head mounting interface.

In a further preferred embodiment, the first arm can be configured for releasably attaching the two antenna heads therein. Preferably, the two antenna heads can be mounted on the first arm such that they lie substantially horizontal with respect to the base frame. Thus, in such embodiments, the clamp structure of the radome measuring clamp is created by the two antenna heads positioned at a distance from each other and connected by the first arm.

The first arm can comprise two antenna head mounting interfaces. This can facilitate mounting two antenna heads therein, for implementing the clamp structure.

Each of the two antenna heads can be configured to be releasably attached to a respective one of the two antenna head mounting interfaces such that the two antenna heads can extend lengthwise substantially perpendicular to the first arm. That is, the antenna heads can extend horizontally, while the first arm extends vertically, thus, creating the clamp structure.

In some embodiments, one of the two antenna heads can be configured to be releasably attached to the second antenna head mounting interfaces and the other of the two antenna heads can be configured to be releasably attached to the third antenna head mounting interfaces. As discussed, the second antenna head mounting interfaces can facilitate mounting an antenna head to the first arm such that the antenna head can extend horizontally.

The radome measuring clamp can comprises two arm extensions and wherein each of the two arm extensions can be configured to be releasably attached to a respective one of the two antenna head mounting interfaces such that the two arm extensions can extend substantially perpendicular to the first arm. Thus, the arm extension can facilitate increasing the distance between the antenna heads and the first arm.

One of the two arm extensions can be configured to be releasably attached to the second antenna head mounting interfaces and the other of the two arm extensions can be configured to be releasably attached to the third antenna head mounting interfaces, such that the two arm extensions can extend lengthwise substantially perpendicular to the first arm.

Each of the antenna heads can be configured to be releasably attached on a respective one of the arm extensions.

In some embodiments, the radome measuring clamp can be configured to be attached to a handling device. Moreover, the handling device can be configured to position the radome measuring clamp in a plurality of positions, such as in any position, within a reachable space of the handling device. That is, the handling device can comprise at least one actuator. For example, the handling device can be a robotic arm.

The attachment between the radome measuring clamp and the handling device can be a releasable attachment. That is, the radome measuring clamp and the handling device can be configured to be releasably attached to each other. This can allow the handling device to not only handle the radome measuring clamp. This can be advantageous, particularly, in production line systems, wherein a handling device (e.g. a robotic arm) handles multiple devices (i.e. performs different tasks by changing the head of the robotic arm).

The radome measuring clamp can comprise at least actuator mount interface which can be configured to facilitate attaching the radome measuring clamp to the handling device.

Similarly, the handling device can comprise a mounting interface which can be configured to mount an external device to the handling device. Moreover, the actuator mount interface of the radome measuring clamp can be compatible with the mounting interface of the handling device. Otherwise, in some embodiments an adapter interface can be provided to make the actuator mount interface of the radome measuring clamp compatible with the mounting interface of the handling device.

The actuator mount interface of the radome measuring clamp can be compatible with at least one standard mounting interface, standard coupling interface or any combination thereof. As such, any standard compatible handling device can be used to handle the radome measuring clamp. This increases the ease of integrating the radome measuring clamp into existing systems or processes, such as, production lines.

For example, the actuator mount interface can be a quick-change coupling, such as, a Zimmer coupling or Schunk coupling.

The radome measuring clamp can comprise a plurality of actuator mount interfaces, wherein each actuator mount interface can be configured to facilitate mounting the radome measuring clamp to the handling device in a respective orientation of the radome measuring clamp relative to the handling device. This can further increase the ease of integrating the radome measuring clamp into existing systems or processes or environments, such as, production lines.

Thus, in some embodiments the actuator mount interface can be provided on a bottom surface of the base frame, wherein the bottom surface of the base frame is substantially perpendicular with the lengthwise direction of the first arm and faces away from the first arm.

Alternatively or additionally, the actuator mount interface can be provided on a lateral surface of the first arm that faces away from the base frame.

Alternatively or additionally, the actuator mount interface can be provided on a surface of the first arm which forms an acute angle of 20 to 60 degrees, such as, 45 degrees with the lengthwise direction of the first arm.

Alternatively or additionally, the actuator mount interface can be provided on a surface of the base frame which forms an acute angle of 20 to 60 degrees, such as, 45 degrees with the lengthwise direction of the first arm.

In some embodiments, the radome measuring clamp can be configured to be rendered in a plurality of configurations. This is particularly facilitated by the modular structure, i.e. releasable attachments, of the radome measuring clamp. The modular structure, can allow for coupling, uncoupling and combining the components of the radome measuring clamp, i.e. the base frame, arm(s), antenna heads, arm extension(s), thus rendering the radome measurement clamp in particular configurations. This can be advantageous as it can allow adapting the radome measuring clamp to a particular scenario or environment.

For example, the radome measuring clamp can be configured to be rendered in a first configuration, by attaching the second arm to the base frame. In this configuration, the clamp structure is created by the two arms extending from the base frame in the same direction.

In yet another example, the radome measuring clamp can be configured to be rendered in a second configuration, by attaching the two antenna heads to the first arm. In this configuration, the clamp structure is created by the two antenna heads extending from the first arm.

Furthermore, the radome measuring clamp can be configured to be rendered from one configuration to another. For example, the radome measuring clamp can be configured to be rendered from the first configuration to the second configuration and from the second configuration to the first configuration. Again, this is facilitated by the modular structure, i.e. releasable attachments, of the radome measuring clamp.

The radome measuring can comprise a first antenna and a second antenna, each attached to a respective one of the two antenna heads.

The first antenna and the second antenna can be releasably attached to the respective antenna head. This can be advantageous as it can allow replacing the antennas, in case of a defective antenna. It also facilitates performing radome measurements with electromagnetic waves with different frequencies, by changing the antennas.

The first antenna and the second antenna can be aligned such that their main lobes intersect. Thus, a measuring signal (i.e. an electromagnetic wave) can travel from one of the antennas to the other.

The first antenna and the second antenna can be a transmitter-receiver antenna pair, i.e. one configured for transmitting electromagnetic waves and the other for receiving electromagnetic waves. Alternatively, the first antenna and the second antenna can be transceiver antennas, i.e. both configured for emitting and receiving electromagnetic waves.

The first antenna and the second antenna can be configured for emitting and/or receiving electromagnetic waves at the same frequency. The frequency of the electromagnetic waves can be at least 20 GHz and at most 300 GHz, preferably, at least 70 GHz and at most 90 GHz. The 70 GHz to 90 GHz frequency band can be particularly advantageous for testing the effect of radomes covering radars used in vehicles (which typically operate at such bands). In general, the frequency of the electromagnetic wave used to measure the effects of the radome, can be the same with the frequency that the radar which will be covered by the radome uses.

The first antenna and the second antenna can be provided at a distance from each other, such that, at least one object can be provided between the antennas. The at least one object can be a device under test, such as, a radome.

As discussed, the first antenna and the second antenna can be a transmitter-receiver antenna pair, i.e. one configured for transmitting electromagnetic waves and the other for receiving electromagnetic waves. Alternatively, the first antenna and the second antenna can be transceiver antennas, i.e. both configured for emitting and receiving electromagnetic waves. However, for the sake of brevity in the following, the first antenna will be referred as a transmitting antenna, configured for emitting electromagnetic waves and the second antenna will be referred as a receiving antenna, configured for receiving electromagnetic waves. Furthermore, to perform a radome measurement, the radome measuring clamp can be configured such that a radome can be positioned between the first antenna and the second antenna. Thus, the electromagnetic waves transmitted by the transmitting antenna can traverse at least a section of the radome.

The radome measuring clamp can be configured to measure the attenuation of an electromagnetic wave traversing through the radome. Alternatively or additionally, the radome measuring clamp can be configured to measure the phase shift caused to an electromagnetic wave when traversing through the radome. Alternatively or additionally the radome measuring clamp can be configured to measure the time of flight (ToF) of the electromagnetic wave from the transmitting antenna to the receiving antenna. The latter can be advantageous as it can allow to determine the phase shift more accurately. Alternatively or additionally, the radome measuring clamp can be configured to measure the reflection of electromagnetic waves caused by the radome. Alternatively or additionally, the radome measuring clamp can be configured to measure deflection of the main beam of the transmitting antenna. Alternatively or additionally, the radome measuring clamp can be configured to measure increasing of the beam width of the transmitting antenna. Alternatively or additionally, the radome measuring clamp can be configured to measure extension of sidelobes of the transmitting antenna. Alternatively or additionally, the radome measuring clamp can be configured to measure the scattering parameters, or S-parameters, describing the transmission of electromagnetic waves from the transmitting antenna, through the radome under test and to receiving antenna.

The transmitting antenna and the receiving antenna can be aligned, such that, the main lobe of the transmitting antenna and the main lobe of the receiving antenna can intersect. When multiple transmitting antennas and multiple receiving antennas are used, the alignment can be done one-by-one, wherein each transmitting antenna is aligned with one receiving antenna, or one-to-many wherein multiple receiving antennas can receive from the same transmitting antennas, or many-to-one wherein one receiving antenna can receive from multiple transmitting antennas, or many-to-many wherein any transmitting antenna can transmit to any receiving antenna. The different aligning configurations can provide multiple ways of performing the radome measurement. For example, in a one-to-one alignment, a single measurement or multiple independent measurements of the radome can be done by the aligned pair of transmission and receiving antenna, i.e. each one-to-one pair of transmission and receiving antennas can measure a corresponding area of the radome.

The transmitting antenna can be configured to emit or radiate electromagnetic waves with a frequency range between 20 - 300 GHz, preferably, between 70 - 90 GHz.

The receiving antenna can be configured to receive electromagnetic waves with a frequency range between 20 - 300 GHz, preferably, between 70 - 90 GHz.

Preferably, the transmitting antenna and the receiving antenna can be configured to operate on the same frequency range. This can allow a signal that is transmitted from the transmitting antenna to be received by the receiving antenna. More preferably, aligned pairs of transmission and receiving antennas can be configured to operate on the same frequency range. That is, different aligned pairs can operate on different frequency ranges while the antennas within the aligned pairs operate with the same frequency. This can allow that multiple radome measurements for different frequency ranges of the measuring signals to be carried out simultaneously.

Furthermore, the frequency range between 20 - 300 GHz, preferably, between 70 - 90 GHz can be advantageous as it matches with the operational frequency range used by radars, particularly automotive radars. Hence, the effect that the radome can have on an automotive radar can be tested.

In some embodiments, the radome can be positioned between the antennas, such that, it can deviate the reflections that may be created between the transmitting antenna and the radome and/or between the receiving antenna and the radome. This can be achieved by positioning the radome in an inclined manner (i.e. not perpendicular to the signal transmission path or the boresight axis of the transmitting antenna). The inclination angle of the radome can be 20° to 160°.

In general, the radome and/or the radome measuring clamp can be positioned such that the electromagnetic waves transmitted by the transmitting antenna can be incident on a surface of the radome with an incidence angle between 20° to 160°, such as 90°.

In some embodiments, the radome measuring clam can be connected with a measuring device. More particularly, the radome measuring clamp can be configured such that a measuring device can be connected to the at least transmitting antenna and to the receiving antenna. The connections can be facilitated by a respective connector, and wherein each of the connectors respectively comprise an electrical conductor, a waveguide or any combination thereof.

The measuring device can be configured to measure at least one difference between the transmitted and received electromagnetic waves. If a radome or radome sample is positioned between the transmitting antenna and receiving antenna, the at least one difference between the transmitted and received electromagnetic waves can be used to infer a feature of the radome. In other words, if the electromagnetic waves emitted by the transmitting antenna, traverse through a radome or radome sample before being received at the receiving antenna, the at least one difference between the transmitted and received electromagnetic waves can be used to infer a feature of the radome. The inferred or deduced feature of the radome can comprise the level of attenuation, phase shift, increase on the time of flight, reflection, refraction, scattering, etc., that the radome can cause. The inferred or deduced feature of the radome can also comprise a decision or determination whether the radome meets one or more preset requirements regarding the effect it can have on the sensing of a radar sensor. The inferred or deduced feature of the radome can also be used to infer an accuracy or sensing indicator of the radar system wherein the radome under test is intended for use.

The transmitting antenna and the receiving antenna can be provided at a distance. The distance between the transmitting antenna and the receiving antenna can be between 10 cm to 1 m.

The transmitting antenna and the receiving antenna can be configured as transceiver antennas, that is, are configured to transmit and receive electromagnetic waves.

A maximum misalignment of 0.05 mm, preferably 0.1 mm, even more preferably 1 mm can be tolerable between the transmitting antenna and the at least one receiving antenna.

In a further aspect the present invention relates to a radome measuring system comprising the radome measuring clamp, a handling device configured to position the radome measuring clamp in a plurality of positions, such as in any position, within a reachable space of the handling device.

Further, the radome measuring system can comprise the measuring device.

The radome measuring system can be configured to measure the attenuation of an electromagnetic wave traversing through the radome. Alternatively or additionally, the radome measuring system can be configured to measure the phase shift caused to an electromagnetic wave when traversing through the radome. Alternatively or additionally the radome measuring system can be configured to measure the time of flight (ToF) of the electromagnetic wave from the transmitting antenna to the receiving antenna. The latter can be advantageous as it can allow to determine the phase shift more accurately. Alternatively or additionally, the radome measuring system can be configured to measure the reflection of electromagnetic waves caused by the radome. Alternatively or additionally, the radome measuring system can be configured to measure deflection of the main beam of the transmitting antenna. Alternatively or additionally, the radome measuring system can be configured to measure increasing of the beam width of the transmitting antenna. Alternatively or additionally, the radome measuring system can be configured to measure extension of sidelobes of the transmitting antenna. Alternatively or additionally, the radome measuring system can be configured to measure the scattering parameters, or S-parameters, describing the transmission of electromagnetic waves from the transmitting antenna, through the radome under test and to the receiving antenna. In a further aspect the present invention relates to a method of measuring the effects of a radome on electromagnetic waves traversing through the radome. The method comprises positioning the radome between at least one transmitting antenna and at least one receiving antenna. Further, the method comprises performing a radome measurement. Performing a radome measurement comprises triggering the at least one transmitting antenna to radiate electromagnetic waves, receiving the transmitted electromagnetic waves by the at least one receiving antenna and measuring at least one difference between the transmitted and received electromagnetic waves. The at least one transmitting antenna and the at least one receiving antenna are attached on the radome measuring clamp according to any of the claims 1 to 12.

In some embodiments, the method can comprise inferring a feature of the radome based on the at least one difference between the transmitted and received electromagnetic waves. That is, based on the radome measurement the following effects caused by the radome on the antenna (or radar or sensor) it is covering, can be measured and/or inferred: attenuation, phase shift and/or time of flight of an electromagnetic wave traversing through the radome, reflection of electromagnetic waves hitting the radome, deflection of the main beam of the antenna, increasing of the beam width of the antenna, extension of sidelobes of the antenna or any combination thereof. Alternatively or additionally, based on a radome measurement the scattering parameters, or S-parameters, can be measured and/or calculated and/or inferred.

In some embodiments, the method can comprise performing the radome measurement at least one time, such as, 1 to 200 times, preferably 20 to 150 times, preferably, 50 to 80 times, before inferring at least one feature of the radome. This can increase the accuracy and/or the confidence of the inferences.

In some embodiments, performing a radome measurement can further comprise changing the relative position between the radome and the at least one transmitting antenna and repeating the radome measurement afterwards. The radome measurement can be performed at least one time, such as, such as, 1 to 200 times, preferably 20 to 150 times, preferably, 50 to 80 times. This way, multiple locations or areas of the radome can be measured.

In some embodiments the method can comprise defining a measurement region of the radome. Furthermore, the method can comprise defining a plurality of measurement cells within the measurement region.

The measurement cells can be defined within the measurement region with a density of 5 to 10 measurement cells per centimeter square, such as, 8 measurement cells per centimeter square.

The measurement cells can be uniformly distributed on the measurement region.

Each of the measurement cells can comprise an area of 50 to 500 millimeter square, preferably 130 to 150 millimeter square, such as, 140 millimeter square.

In some embodiments, the method can comprise positioning the radome and the antennas such that a measurement cell is placed between the antennas. That is, an electromagnetic wave emitted by the transmission antenna can be incident on a measurement cell of the radome. This can allow performing a radome measurement of the measurement cell. That is, the transmitted signal can pass through the measurement cell.

In some embodiments, a plurality of measurement cells, such as, each measurement cell can be measured by positioning the radome and the antennas such that a measurement cell is placed between the antennas, then performing a measurement and then moving to the next measurement cell.

That is, in some embodiments the method can comprise changing the position of the radome relative to the antennas from a first position to a second position. This can be done by either moving the radome or by moving the antennas or both.

Furthermore, the radome measurement can be performed while the position of the radome relative to the antennas is changing from the first position to the second position, without changing the relative speed between radome and the antennas. That is, the radome can be measured at different points (i.e. measurement cells) without the need of stopping the relative motion between the radome and the antennas. This can be advantageous as it can make the process more time efficient.

The relative speed between the radome and the antennas can be between 100 and 300 mm/s, such as, 200 mm/s.

This way a radome can be measured very fast and with high accuracy (as it can be sampled in multiple points). For example, in a radome a measurement region with an area of 90centimeter square can be defined. In the measurement region 72 measurement cells can be defined uniformly distributed on the measurement region. The position between the antennas and the radome can be adjusted such that each measurement cell can be measurement, e.g., in a scanning motion. The relative motion between the antennas and the radome can be 200 mm/s. At this speed, the radome can be measured within 5 seconds.

Measuring one measurement cell can be performed within at least 1 millisecond, such as within at least 10 milliseconds, for example, within 45 milliseconds.

In some embodiments, the method can comprise performing a prior referencing with an empty measurement. The referencing with an empty measurement can consist on performing a measurement without providing a radome between the at least one transmission antenna and at least one receiving antenna. That is, means that the measuring signal does not traverse through the radome before reaching the at least one receiving antenna. The referencing with an empty measurement can be advantageous as a feature of the medium (without the radome) between the transmission and receiving antennas can be inferred. The feature or measurement of the medium can be used to compensate the medium's effect on the radome measuring signals during a radome measurement. Thus, only the effect of the radome on the measuring signals (transmitted from the at least one transmission antenna to the at least one receiving antenna) can be considered.

In other words, the process of a radome measurement is based on measuring the effect of the mediums between the at least one transmission antenna and the at least one receiving antenna. The measuring signal can be affected by each of the mediums it traverses through and the medium between the at least one transmission antenna and at least one receiving antenna can comprise the radome, air, etc. However, only the effect of the radome on the measuring signal can be advantageous to be measured for inferring a feature of the radome. Thus, referencing with an empty measurement, can allow measuring the effect of all other mediums between the at least one transmission antenna and the at least one receiving antenna without the radome. Hence, when a measurement of the radome is performed, the effect of the other mediums can be compensated.

In a similar manner, referencing with an empty measurement can allow, that further errors be compensated. For example, a misalignment between the transmission and receiving antenna can cause extra difference between the transmitted and received electromagnetic waves. This further effect on the measuring signal, caused by the misalignment between the antennas, can be measured during the referencing with an empty measurement and hence, can be compensated when the radome measurement is performed.

Referencing with an empty measurement, can allow the compensation of measurement errors that can be caused by temperature changes. Changes on the temperature of the environment can cause changes of the components of the radome measuring clamp. This can affect the operation of the components of the system, for example, the conversion gain of the frequency converters (if provided) can change with temperature. Furthermore, the propagation properties of the medium between the transmission and receiving antennas can also change when temperature changes. The above-mentioned effects (and also other effects that may be caused by temperature change of the environment) can be compensated by the referencing with an empty measurement.

Furthermore, as the medium(s) between the antennas can change, e.g. due to changing of temperature, humidity, dust, etc., it can be advantageous to perform the referencing with an empty measurement shortly, such as 1 to 10 seconds, before the radome measurement. In general, the more updated the effect of external factors on the measuring signal (such as, effect form other mediums other than the radome, misalignment of antennas, etc.) the more accurate the results of the radome measurement can be.

Furthermore, the method can comprise positioning the radome such that the radome is not between the at least one transmitting antenna and the at least one receiving antenna. This can be performed after the respective radome is measured.

Then, a post referencing with an empty measurement can further be performed in a similar way to the prior referencing.

In some embodiments, the method can comprise comparing the prior referencing with an empty measurement with the post referencing with an empty measurement and determining based on the comparison a validity of the radome measurement. That is, it can be determined whether an error or environmental change occurred during the radome measurement. This can provide feedback information on the accuracy of the radome measurement.

In some embodiments, the method can comprise measuring a plurality of radomes in series. That is, a plurality of radomes can be measured one after the other. More particularly, the method can be repeated for at least one further radome.

Thus, a second radome can be measured after a first radome. In such embodiments, the post referencing performed while measuring the first radome can be used a prior measuring for measuring the second radome. This can increase the time efficiency of the method, particularly when a plurality of radomes are to be measured. In some embodiments, the method can comprise positioning a reference sample between the antennas instead of the radome. This can facilitate performing a stability check by performing a radome measurement of the reference sample in step.

More particularly, the method can comprise comparing at least one measured difference between the transmitted and received electromagnetic wave with at least one expected difference between the transmitted and received electromagnetic waves wherein the measured difference and the expected difference correspond to the reference sample. Put simply, by measuring a reference sample with known properties possible errors or issues can be detected. This can also allow performing calibrations such that when measuring a reference sample the measured results do not differ from the expected results.

In some embodiments, the method can further comprise performing time-gating before the step of measuring at least one difference between the transmitted and received electromagnetic waves, such that, interference of the received signal considered while measuring at least one difference between the transmitted and received electromagnetic waves can be minimized. More particularly, the received signal at the at least one receiving antenna can be composed of the measuring signal transmitted directly from the at least one transmission antenna to the at least one receiving antenna and from reflections of the measuring signal created by the surface of the radome and/or antennas and/or other structures traversed or hit by the measuring signal. As the reflections follow a longer path then the direct transmission, the reflections arrive at the at least one receiving antenna with a certain delay after the direct transmission. Hence, it can be expected that the measuring signal following a direct path (i.e. without reflections) and the reflections following a longer path are separated in time. Time-gating technique can allow that only the received signal without reflections can be considered for measuring at least one difference between the transmitted and received electromagnetic waves.

The at least one transmitting antenna and the at least one receiving antenna can be attached on the radome measuring clamp.

Furthermore, the method can comprise rendering the radome measuring clamp in at least one of the plurality of configurations prior to carrying out the rest of the method.

The following embodiments/examples, not forming a part of the claimed invention which is defined by the appended claims, are useful for understanding of the invention and the present technology.

Below, device embodiments will be discussed. These embodiments are abbreviated by the letter "D" followed by a number. Whenever reference is herein made to "device embodiments", these embodiments are meant.

**D1.** A radome measuring clamp (10) configured to facilitate performing a radome measurement, the radome measuring clamp (10) comprising
a base frame (4);
a first arm (3) attached to the base frame (4);
two antenna heads (1), each configured for attaching at least one antenna therein.

### Attachments/Modularity

**D2.** The radome measuring clamp (10) according to any of the preceding embodiments, wherein the base frame (4) and the first arm (3) are configured to be releasably attached to each other.

**D3.** The radome measuring clamp (10) according to the preceding embodiment, wherein the base frame (4) comprises at least one base-arm mounting interface (43) configured to facilitate releasably attaching the first arm (3) to the base frame (4).

**D4.** The radome measuring clamp (10) according to any of the 2 preceding embodiments, wherein the first arm (3) comprises at least one arm-base mounting interface (34) configured to facilitate releasably attaching the first arm (3) to the base frame (4).

**D5.** The radome measuring clamp (10) according to the two preceding embodiments, wherein the base-arm mounting interface (43) and the arm-base mounting interface (34) are compatible.

**D6.** The radome measuring clamp (10) according to any of the preceding embodiments, wherein the first arm (3) is configured for releasably attaching at least one of the two antenna heads (1) therein.

**D7.** The radome measuring clamp (10) according to the preceding embodiment, wherein the first arm (3) comprises at least one antenna head mounting interface (31), each configured to facilitate releasably attaching one antenna head (1) to the first arm (3).

**D8.** The radome measuring clamp (10) according to the preceding embodiment, wherein the first arm (3) comprises a first antenna head mounting interface (31A)
configured to facilitate releasably attaching one antenna head (1) therein, such that the antenna head (1) extends lengthwise substantially parallel to the first arm (3).

That is, the first antenna head mounting interface (31A) allows the antenna head (1) to be mounted in a substantially vertical position with respect to the base frame (4).

**D9.** The radome measuring clamp (10) according to any of the 2 preceding embodiments, wherein the first arm (3) comprises a second antenna head mounting interface (31B)
configured to facilitate releasably attaching one antenna head (1) therein, such that the antenna head (1) extends lengthwise substantially perpendicular to the first arm (3).

That is, the second antenna head mounting interface (31B) allows the antenna head (1) to be mounted in a substantially horizontal position with respect to the base frame (4).

**D10.** The radome measuring clamp (10) according to any of the 3 preceding embodiments, wherein the first arm (3) comprises a third antenna head mounting interface (31C)
configured to facilitate releasably attaching one antenna head (1) therein, such that the antenna head (1) extends lengthwise substantially perpendicular to the first arm (3).

That is, the third antenna head mounting interface (31C) allows the antenna head (1) to be mounted in a substantially horizontal position with respect to the base frame (4).

**D11.** The radome measuring clamp (10) according to the 2 preceding embodiments, wherein the second antenna head mounting interface (31B) and the third antenna head mounting interface (31C) are provided at different distances from the base frame (4).

**D12.** The radome measuring clamp (10) according to any of the preceding embodiments, wherein each of the two antenna heads (1) is configured to be releasably attached to the first arm (3).

**D13.** The radome measuring clamp (10) according to the preceding embodiment, wherein each of the two antenna heads (1) comprises at least one arm mounting interface (13).

**D14.** The radome measuring clamp (10) according to the preceding embodiment and embodiment D7, wherein the antenna head mounting interface (31) and the arm mounting interface (13) are compatible.

### Arm extension

**D15.** The radome measuring clamp (10) according to any of the preceding embodiments, wherein the radome measuring clamp (10) comprises an arm extension (2) and wherein the arm extension (2) is configured to facilitate extending the length of the first arm (3).

**D16.** The radome measuring clamp (10) according to the preceding embodiment, wherein the arm extension (2) is configured to be releasably attached
with the first arm (3) and with one of the at least two antenna heads (1) and
between the first arm (3) and the one of the at least two antenna heads (1) for increasing a distance between the first arm (3) and the one of the at least two antenna heads (1).

**D17.** The radome measuring clamp (10) according to the preceding embodiment, wherein the arm extension (2) is further configured such that two arm extensions (2) are releasably attachable with each other.

**D18.** The radome measuring clamp (10) according to the preceding embodiment, wherein at least one further arm extension (2') is configured to be releasably attached between first arm (3) and the arm extension (2) for further increasing a distance between the first arm (3) and the one of the at least two antenna heads (1).

**D19.** The radome measuring clamp (10) according to any of the 2 preceding embodiments, wherein at least one further arm extension (2') is configured to be releasably attached between the one of the at least two antenna heads (1) and the arm extension (2) for further increasing a distance between the first arm (3) and the one of the at least two antenna heads (1).

**D20.** The radome measuring clamp (10) according to any of the 5 preceding embodiments, and with the features of embodiments D7 and D13, wherein the arm extension (2) comprises at least one antenna head mounting interface (31) and at least one arm mounting interface (13).

### Dual-arm clamp

**D21.** The radome measuring clamp (10) according to any of the preceding embodiments, wherein the radome measuring clamp (10) comprises a second arm (5).

**D22.** The radome measuring clamp (10) according to the preceding embodiment, wherein the second arm (5) is identical to the first arm (5).

**D23.** The radome measuring clamp (10) according to any of the 2 preceding embodiments, wherein the base frame (4) and the second arm (5) are configured to be releasably attached to each other.

**D24.** The radome measuring clamp (10) according to any of the 3 preceding embodiments, wherein the base frame (4) comprises at least two base-arm mounting interfaces (43), each configured to facilitate releasably attaching any of the first arm (3) and the second arm (5) to the base frame (4).

**D25.** The radome measuring clamp (10) according to any of the 4 preceding embodiments, wherein the first arm (3) and the second arm (5) protrude along the same direction from the base frame (4).

**D26.** The radome measuring clamp (10) according to any of the 5 preceding embodiments, wherein the first arm (3) and the second arm (5) are mirror symmetric.

**D27.** The radome measuring clamp (10) according to any of the 6 preceding embodiments, wherein the first arm (3) and the second arm (5) extend lengthwise substantially perpendicular to the base frame (4).

That is, the first arm and the second arm are substantially vertical with respect to the base frame.

**D28.** The radome measuring clamp (10) according to any of the 7 preceding embodiments, wherein the first arm (3) and the second arm (5) comprise a substantially straight lengthwise extension.

That is, the length of the first arm and the second arm at any point in the same vertical cross section can be a linear function of the distance from the base frame.

**D29.** The radome measuring clamp (10) according to any of the 8 preceding embodiments and without the features of the preceding embodiment, wherein the first arm (3) and the second arm (5) comprise a non-straight lengthwise extension, such as, a curved lengthwise extension.

**D30.** The radome measuring clamp (10) according to any of the 9 preceding embodiments, wherein the first arm (3) and the second arm (5) are longitudinal in the direction of protrusion.

**D31.** The radome measuring clamp (10) according to any of the 10 preceding embodiments, wherein each of the antenna heads (1) is configured to be releasably attached on a respective one of the first arm (3) and second arm (5).

**D32.** The radome measuring clamp (10) according to any of the 11 preceding embodiments and with the features of embodiment D8, wherein each of the antenna heads (1) is configured to be releasably attached on a respective one of
the first antenna head mounting interface (31A) of the first arm (3) and
the first antenna head mounting interface (31A) of the second arm (5).

Thus, both of the antenna heads extend lengthwise substantially parallel to the first arm and to the second arm, i.e., both antenna heads are in a substantially vertical position with respect to the base frame.

**D33.** The radome measuring clamp (10) according to any of the 12 preceding embodiments and with the features of embodiment D15, wherein the radome measuring clamp (10) comprises a respective arm extension (2) for the first arm (3) and the second arm (5).

**D34.** The radome measuring clamp (10) according to the preceding embodiment and with the features of embodiment D8, wherein each arm extension (2) is configured to be releasably attached on a respective one of
the first antenna head mounting interface (31A) of the first arm (3) and
the first antenna head mounting interface (31A) of the second arm (5),
such that the two arm extensions (2) extend lengthwise substantially parallel to the first arm (3) and to the second arm (5), respectively.

**D35.** The radome measuring clamp (10) according to the preceding embodiment, wherein each of the antenna heads (1) is configured to be releasably attached on a respective one of the arm extensions (2), such that each arm extension (2) is positioned between the respective antenna head (1) and the respective first antenna head mounting interface (31A).

### Single-arm clamp

**D36.** The radome measuring clamp (10) according to any of the preceding embodiments, wherein the first arm (3) is configured for releasably attaching the two antenna heads (1) therein.

**D37.** The radome measuring clamp (10) according to the preceding embodiment and with the features of embodiment D7, wherein the first arm comprises at least two antenna head mounting interfaces (31).

**D38.** The radome measuring clamp (10) according to the preceding embodiment wherein each of the two antenna heads (1) is configured to be releasably attached to a respective one of the two antenna head mounting interfaces (31) such that the two antenna heads (1) extend lengthwise substantially perpendicular to the first arm (3).

**D39.** The radome measuring clamp (10) according to any of the 3 preceding embodiments and with the features of embodiments D9 and D10,
wherein one of the two antenna heads (1) is configured to be releasably attached to the second antenna head mounting interfaces (31B)
and the other of the two antenna heads (1) is configured to be releasably attached to the third antenna head mounting interfaces (31C).

**D40.** The radome measuring clamp (10) according to any of the 3 preceding embodiments and with the features of embodiment D15,
wherein the radome measuring clamp (10) comprises two arm extensions (2) and
wherein each of the two arm extensions (2) is configured to be releasably attached to a respective one of the two antenna head mounting interfaces (31) such that the two arm extensions (2) extend substantially perpendicular to the first arm (3).

**D41.** The radome measuring clamp (10) according to any of the 4 preceding embodiments and with the features of embodiments D9 and D10,
wherein the radome measuring clamp (10) comprises two arm extensions (2) and
wherein one of the two arm extensions (2) is configured to be releasably attached to the second antenna head mounting interfaces (31B) and
the other of the two arm extensions (2) is configured to be releasably attached to the third antenna head mounting interfaces (31C),
such that the two arm extensions (2) extend lengthwise substantially perpendicular to the first arm (3).

**D42.** The radome measuring clamp (10) according to any of the 2 preceding embodiments, wherein each of the antenna heads (1) is configured to be releasably attached on a respective one of the arm extensions (2).

### Actuator mounting interface

**D43.** The radome measuring clamp (10) according to any of the preceding embodiments, wherein the radome measuring clamp (10) is configured to be attached to a handling device,
wherein the handling device is configured to position the radome measuring clamp (10) in a plurality of positions, such as in any position, within a reachable space of the handling device.

**D44.** The radome measuring clamp (10) according to the preceding embodiment, wherein the handling device comprises a robotic arm.

**D45.** The radome measuring clamp (10) according to the penultimate embodiment, wherein the handling device comprises
a linear translation stage, preferably a motorized linear translation stage,
a two linear translation stage configured for two dimensional movements, preferably a motorized two linear translation stage,
a three linear translation stage configured for three dimensional movements, preferably a motorized three linear translation stage,
or any combination thereof.

**D46.** The radome measuring clamp (10) according to any of the 3 preceding embodiments, wherein the attachment between the radome measuring clamp (10) and the handling device is a releasable attachment.

**D47.** The radome measuring clamp (10) according to any of the 4 preceding embodiments, wherein the radome measuring clamp (10) comprises at least one actuator mount interface (6) configured to facilitate attaching the radome measuring clamp (10) to the handling device.

**D48.** The radome measuring clamp (10) according to the preceding embodiment, wherein the handling device comprises a mounting interface, configured to mount an external device to the handling device and
wherein the actuator mount interface (6) of the radome measuring clamp is compatible with the mounting interface of the handling device.

**D49.** The radome measuring clamp (10) according to any of the 2 preceding embodiments, wherein the actuator mount interface (6) of the radome measuring clamp is compatible with at least one standard mounting interface, standard coupling interface or any combination thereof.

**D50.** The radome measuring clamp (10) according to any of the 3 preceding embodiments, wherein the actuator mount interface (6) is a quick-change coupling, such as, a Zimmer coupling or Schunk coupling.

**D51.** The radome measuring clamp (10) according to any of the 4 preceding embodiments, wherein the radome measuring clamp (10) comprises a plurality of actuator mount interfaces (6),
wherein each actuator mount interface (6) is configured to facilitate mounting the radome measuring clamp (10) to the handling device in a respective orientation of the radome measuring clamp (10) relative to the handling device.

**D52.** The radome measuring clamp (10) according to any of the 5 preceding embodiments, wherein the actuator mount interface (6) is provided on a bottom surface of the base frame (4), wherein the bottom surface of the base frame (4) is substantially perpendicular with the lengthwise direction of the first arm (2) and faces away from the first arm (3).

**D53.** The radome measuring clamp (10) according to any of the 6 preceding embodiments, wherein the actuator mount interface (6) is provided on a lateral surface of the first arm (3) that faces away from the base frame (4).

**D54.** The radome measuring clamp (10) according to any of the 7 preceding embodiments, wherein the actuator mount interface (6) is provided on a surface of the first arm (3) which forms an acute angle of 20 to 60 degrees, such as, 45 degrees with the lengthwise direction of the first arm (2).

**D55.** The radome measuring clamp (10) according to any of the 8 preceding embodiments, wherein the actuator mount interface (6) is provided on a surface of the base frame (4) which forms an acute angle of 20 to 60 degrees, such as, 45 degrees with the lengthwise direction of the first arm (2).

### Configurations

**D56.** The radome measuring clamp (10) according to any of the preceding embodiments, wherein the radome measuring clamp (10) is configured to be rendered in a plurality of configurations.

**D57.** The radome measuring clamp (10) according to the preceding embodiment and with the features of embodiment D21, wherein the radome measuring clamp (10) is configured to be rendered in a first configuration, by attaching the second arm (5) to the base frame (4).

**D58.** The radome measuring clamp (10) according to the preceding embodiment and with the features of embodiment D36, wherein the radome measuring clamp (10) is configured to be rendered in a second configuration, by attaching the two antenna heads (1) to the first arm (3).

**D59.** The radome measuring clamp (10) according to the 2 preceding embodiments, wherein the radome measuring clamp (10) is configured to be rendered from the first configuration to the second configuration and from the second configuration to the first configuration.

### Antennas

**D60.** The radome measuring clamp (10) according to any of the preceding embodiments, further comprising a first antenna and a second antenna, each attached to a respective one of the two antenna heads (1).

**D61.** The radome measuring clamp (10) according to the preceding embodiment, wherein the first antenna and the second antenna are releasably attached to the respective antenna head (1).

**D62.** The radome measuring clamp (10) according to any the 2 preceding embodiments, wherein the first antenna and the second antenna are aligned such that their main lobes intersect.

**D63.** The radome measuring clamp (10) according to any of the 3 preceding embodiments,
wherein the first antenna is configured for emitting electromagnetic waves and the second antenna is configured for receiving electromagnetic waves, or
wherein the second antenna is configured for emitting electromagnetic waves and the first antenna is configured for receiving electromagnetic waves, or
wherein the first antenna and the second antenna are configured both for emitting and receiving electromagnetic waves.

**D64.** The radome measuring clamp (10) according to the preceding embodiment, wherein the first antenna and the second antenna are configured for emitting and/or receiving electromagnetic waves at the same frequency.

**D65.** The radome measuring clamp (10) according to the preceding embodiment, wherein the electromagnetic waves comprise a frequency of at least 20 GHz and at most 300 GHz, preferably, at least 70 GHz and at most 90 GHz.

**D66.** The radome measuring clamp (10) according to any of the 6 preceding embodiments, wherein the first antenna and the second antenna are provided at a distance from each other, such that, at least one object can be provided between the antennas.

**D67.** The radome measuring clamp (10) according to the preceding embodiment, wherein the at least one object is a device under test, such as, a radome.

### Radome measurement

**D68.** The radome measuring clamp (10) according to any of the 8 preceding embodiments,
wherein the first antenna is a transmitting antenna (7T), configured for emitting electromagnetic waves and the second antenna is a receiving antenna (7R), configured for receiving electromagnetic waves and
wherein the radome measuring clamp (10) is configured such that a radome (15) can be positioned between the first antenna and the second antenna.

**D69.** The radome measuring clamp (10) according to the preceding embodiment, wherein the electromagnetic waves transmitted by the transmitting antenna traverse at least a section of the radome (15).

**D70.** The radome measuring clamp (10) according to any of the 2 preceding embodiments, wherein the radome measuring clamp (10) is configured to measure at least one of:
- attenuation of an electromagnetic wave traversing through the radome (15),
- difference between the attenuation of an electromagnetic caused when the radome (15) is positioned between the antennas (7T, 7R) and when the radome (15) is not positioned between the antennas (7T, 7R),
- time of flight (ToF) of the electromagnetic wave from the transmitting antenna (7T) to the receiving antenna (7R),
- difference between the ToF of the electromagnetic wave from the transmitting antenna (7T) to the receiving antenna (7R) when the radome (15) is positioned between the antennas (7T, 7R) and when the radome (15) is not positioned between the antennas (7T, 7R),
- phase shift caused of an electromagnetic wave cause by the radome (15),
- difference between the phase shift of an electromagnetic wave caused when the radome (15) is positioned between the antennas (7T, 7R) and when the radome (15) is not positioned between the antennas (7T, 7R),
- reflection of an electromagnetic wave caused by the radome (15),
- deflection of the main beam of the transmitting antenna (7T) due to the radome (15),
- increasing of the beam width of the transmitting antenna (7T) due to the radome (15),
- extension of sidelobes of the transmitting antenna (7T) due to the radome (15),
- the scattering parameters, or S-parameters, of the transmission of electromagnetic waves from the transmitting antenna (7T) to the receiving antenna (7R).

**D71.** The radome measuring clamp (10) according to any of the 3 preceding embodiments, wherein the transmitting antenna (7T) and the receiving antenna (7R) are aligned, such that, the main lobe of the transmitting antenna (7T) and the main lobe of the receiving antenna (7R) intersect.

**D72.** The radome measuring clamp (10) according to any of the 4 preceding embodiments, wherein the transmitting antenna (7T) is configured for emitting or radiating electromagnetic waves with a certain frequency, such as, at least 20 GHz and at most 300 GHz, preferably, at least 70 GHz and at most 90 GHz.

**D73.** The radome measuring clamp (10) according to any of the 5 preceding embodiments, wherein the receiving antenna (7T) is configured for receiving electromagnetic waves with a certain frequency, such as, at least 20 GHz and at most 300 GHz, preferably, at least 70 GHz and at most 90 GHz.

**D74.** The radome measuring clamp (10) according to any of the 6 preceding embodiments, wherein the incidence angle of the electromagnetic waves transmitted by the transmitting antenna (7T) on the radome (15) is between 20° to 160°, such as, 90°.

**D75.** The radome measuring clamp (10) according to any of the 7 preceding embodiments, the radome measuring clamp (10) is configured such that a measuring device (14) is connected to the at least transmitting antenna (7T) and to the receiving antenna (7R) by a respective connector, and wherein each of the connectors respectively comprise ab electrical conductors, a waveguide or any combination thereof.

**D76.** The radome measuring clamp (10) according to any of the 8 preceding embodiments, wherein the distance between the transmitting antenna (7T) and the receiving antenna (7R) is between 10 cm to 1 m.

**D77.** The radome measuring clamp (10) according to any of the 9 preceding embodiments, wherein the transmitting antenna (7T) and the receiving antenna (7R) are configured as transceiver antennas (10), that is, are configured to transmit and receive electromagnetic waves.

**D78.** The radome measuring clamp (10) according to any of the 10 preceding embodiments, wherein a maximum misalignment of 0.05 mm, preferably 0.1 mm, even more preferably 1 mm is tolerable between the at least one transmitting antenna (7T) and the at least one receiving antenna (7R).

### Antenna housing

**D79.** The radome measuring clamp (10) according to any of the preceding embodiments, wherein the radome measuring clamp (10) comprises at least two antenna housings (70) each configured to encapsulate an antenna.

**D80.** The radome measuring clamp (10) according to the preceding embodiment, wherein each of the antenna housing (70) is configured to be attached to a respective antenna head (1).

**D81.** The radome measuring clamp (10) according to the preceding embodiment, wherein the antenna housing (70) comprises a back side,
wherein the back side refers to the surface of the antenna housing (70) that contacts the antenna head (1), when attached to the antenna head (1), and
wherein the back side comprises a coating material configured to absorb electromagnetic waves.

**D82.** The radome measuring clamp (10) according to the preceding embodiment, wherein the coating material of the back side of the antenna housing (70) comprises a radio-frequency absorber foam material.

**D83.** The radome measuring clamp (10) according to any of 4 the preceding embodiments, wherein each of the antenna housing (70) comprises a front side (72), provided such that it can intercept an electromagnetic wave that is transmitted from or received by the antenna encapsulated by the antenna housing (70).

**D84.** The radome measuring clamp (10) according to the preceding embodiment, wherein the front side (72) can comprise an inclined surface (72) provided inclined with respect to the direction of transmission/reception of the antenna encapsulated by the antenna housing (70).

**D85.** The radome measuring clamp (10) according to the preceding embodiment, wherein the boresight angle of the antenna encapsulated by the antenna housing (70) forms with the inclined surface (72) an acute angle between 20 to 80 degrees, preferably 45 to 75 degrees, such as 72 degrees.

**D86.** The radome measuring clamp (10) according to any of the 3 preceding embodiments, wherein the thickness of the front side (72) is configured to facilitate the creation of destructive interference between reflections created by the front side (72).

Particularly, the thickness of the front side (72) can be configured to facilitate the creation of destructive interference between reflections created by the front surface and the back surface of the front side (72). The front side (72) of the antenna housing (70) can interchangeably be referred to as an antenna cover (72).

**D87.** The radome measuring clamp (10) according to any of the 4 preceding embodiments, wherein the front side (72) comprises a plastic material, such as, polyamide (PA) or polyethylene terephthalate (PET).

### Electronic interface

**D88.** The radome measuring clamp (10) according to any of the preceding embodiment, wherein the radome measuring clamp (10) comprises at least one electronic interface (8).

**D89.** The radome measuring clamp (10) according to the preceding embodiment, wherein the at least one electronic interface (8) is provided on the first arm (3).

**D90.** The radome measuring clamp (10) according to any of the 2 preceding embodiments, wherein the at least one electronic interface (8) is provided on the base frame (4).

**D91.** The radome measuring clamp (10) according to any of the 3 preceding embodiments, wherein the at least one electronic interface (8) facilitates connecting at least one power cable, at least one ethernet cable, at least one coaxial cable or any combination thereof to the radome measuring clamp (10).

It will be understood that other cables and/or data connection means can be provided by the at least one electronic interface (8).

Below, system embodiments will be discussed. These embodiments are abbreviated by the letter "S" followed by a number. Whenever reference is herein made to "system embodiments", these embodiments are meant.

**S1.** A radome measuring system comprising
a radome measuring clamp (10) according to any of the preceding device embodiments;
a handling device configured to position the radome measuring clamp (10) in a plurality of positions, such as in any position, within a reachable space of the handling device.

**S2.** The radome measuring system according to the preceding embodiment and with the features of embodiment D60,
wherein the first antenna of the radome measuring clamp (10) is a transmitting antenna (7T), configured for emitting electromagnetic waves and the second antenna of the radome measuring clamp (10) is a receiving antenna (7R), configured for receiving electromagnetic waves.

**S3.** The radome measuring system according to the preceding embodiment further comprising a measuring device configured to measure at least one difference between the transmitted and received electromagnetic waves for inferring a feature of a radome (15) positioned between the at least one transmitting antenna (7T) and the at least one receiving antenna (7R).

**S4.** The radome measuring system according to the preceding embodiment, wherein the system is configured to measure at least one of:
- attenuation of an electromagnetic wave traversing through the radome (15),
- difference between the attenuation of an electromagnetic caused when the radome (15) is positioned between the antennas (7T, 7R) and when the radome (15) is not positioned between the antennas (7T, 7R),
- time of flight (ToF) of the electromagnetic wave from the transmitting antenna (7T) to the receiving antenna (7R),
- difference between the ToF of the electromagnetic wave from the transmitting antenna (7T) to the receiving antenna (7R) when the radome (15) is positioned between the antennas (7T, 7R) and when the radome (15) is not positioned between the antennas (7T, 7R),
- phase shift caused of an electromagnetic wave cause by the radome (15),
- difference between the phase shift of an electromagnetic wave caused when the radome (15) is positioned between the antennas (7T, 7R) and when the radome (15) is not positioned between the antennas (7T, 7R),
- reflection of an electromagnetic wave caused by the radome (15),
- deflection of the main beam of the transmitting antenna (7T) due to the radome (15),
- increasing of the beam width of the transmitting antenna (7T) due to the radome (15),
- extension of sidelobes of the transmitting antenna (7T) due to the radome (15),
- the scattering parameters, or S-parameters, of the transmission of electromagnetic waves from the transmitting antenna (7T) to the receiving antenna (7R).

Below, method embodiments will be discussed. These embodiments are abbreviated by the letter "M" followed by a number. Whenever reference is herein made to "method embodiments", these embodiments are meant.

**M1.** A method of measuring the effects of a radome on electromagnetic waves traversing through the radome, the method comprising the steps of:
(a) positioning a radome (15) between at least one transmitting antenna (7T) and at least one receiving antenna (7R);
(b) performing a radome measurement, wherein performing a radome measurement comprises:
   (i) triggering the at least one transmitting antenna (7T) to radiate electromagnetic waves,
   (ii) receiving the transmitted electromagnetic waves in step (i) by the at least one receiving antenna (7R),
   (iii) measuring at least one difference between the transmitted and received electromagnetic waves.

**M2.** The method according to the preceding embodiment, further comprising
(c) inferring a feature of the radome (15) based on the at least one difference between the transmitted and received electromagnetic waves.

**M3.** The method according to the 2 preceding embodiments, the method comprising performing step (b) at least one time, such as, 1 to 200 times, preferably 20 to 150 times, preferably, 50 to 80 times, before performing step (c).

**M4.** The method according to any of the preceding method embodiments, wherein step (b) further comprises:
(iv) changing the relative position between the radome (15) and the at least one transmitting antenna (7T),
(v) repeating sub-steps (i), (ii), (iii) after sub-step (iv).

**M5.** The method according to the preceding embodiment, wherein steps (iv) and (v) are performed at least one time, such as, such as, 1 to 200 times, preferably 20 to 150 times, preferably, 50 to 80 times.

### Measurement region and cells

**M6.** The method according to any of the preceding method embodiments, wherein the method comprises defining a measurement region of the radome (15).

**M7.** The method according to the preceding embodiment, wherein the method comprises defining a plurality of measurement cells within the measurement region.

**M8.** The method according to the preceding embodiment, wherein defining a plurality of measurement cells within the measurement region comprises
defining the measurement cells within the measurement region with a density of 5 to 10 measurement cells per centimeter square, such as, 8 measurement cells per centimeter square.

**M9.** The method according to any of the 2 preceding embodiments, wherein the measurement cells are uniformly distributed on the measurement region.

**M10.** The method according to any of the 3 preceding embodiments, wherein each of the measurement cells comprises an area of 50 to 500 millimeter square, preferably 130 to 150 millimeter square, such as, 140 millimeter square.

**M11.** The method according to any of the 4 preceding embodiments, wherein the method comprises performing step (a) such that a measurement cell is between the at least one transmitting antenna (7T) and at least one receiving antenna (7R).

**M12.** The method according to the preceding embodiment, wherein the transmitted signal passes through the measurement cell.

**M13.** The method according to any of the 2 preceding embodiments, wherein the method comprises performing steps (a) and (b) for a plurality of measurement cells.

**M14.** The method according to any of the 3 preceding embodiments, wherein the method comprises performing steps (a) and (b) once for each measurement cells.

### Continuous motion measurement

**M15.** The method according to any of the preceding method embodiments,
wherein the method comprises changing the position of the radome (15) relative to the antennas (7T, 7R) from a first position to a second position, and
wherein step (b) is performed while the position of the radome (15) relative to the antennas (7T, 7R) is changing from the first position to the second position, without changing the relative speed between radome (15) and the antennas (7T, 7R).

**M16.** The method according to the preceding embodiment, wherein the relative speed between the radome (15) and the antennas (7T, 7R) is between 100 and 500 mm/s, such as, 200 mm/s.

### Referencing measurements

**M17.** The method according to any of the preceding method embodiments, further comprising performing a prior referencing with an empty measurement by additionally performing step (b) prior to step (a).

**M18.** The method according to any of the preceding method embodiments, wherein the method comprises
(d) positioning the radome (15) such that the radome (15) is not between the at least one transmitting antenna (7T) and the at least one receiving antenna (7R).

**M19.** The method according to the preceding embodiment, wherein the method comprises performing step (d) after steps (a) and (b).

**M20.** The method according to the preceding embodiment, further comprising performing a post referencing with an empty measurement by additionally performing step (b) after step (d).

That is the method can be performed in the following sequence: (b), (a), (b), (d), (b).

**M21.** The method according to the 4 preceding embodiments, wherein the method comprises
comparing the prior referencing with an empty measurement with the post referencing with an empty measurement,
determining based on the comparison a validity of the radome measurement.

**M22.** The method according to any of the preceding embodiments, wherein the method comprises measuring a plurality of radomes (15) in series.

That is, a plurality of radomes can be measured one after the other. That is, the method can be repeated for at least one further radome.

**M23.** The method according to the preceding embodiment and with the features of embodiments M17 and M20, wherein a second radome is measured after a first radome and wherein the post referencing performed while measuring the first radome is used a prior measuring for measuring the second radome.

### Reference sample

**M24.** The method according to any of the preceding method embodiments,
wherein the radome (15) positioned between the at least one transmitting antenna (7T) and at least one receiving antenna (7R) in step (a) is a reference sample and
wherein the method comprises performing a stability check by performing a radome measurement of the reference sample in step (b).

**M25.** The method according to the preceding embodiment, wherein the method comprises
comparing at least one measured difference between the transmitted and received electromagnetic wave in step (b) with at least one expected difference between the transmitted and received electromagnetic waves,
wherein the measured difference and the expected difference correspond to the reference sample.

### Time-gating

**M26.** The method according to any of the preceding method embodiments, wherein the method further comprises performing time-gating before sub-step (iii), such that, interference of the received signal considered in step (iii) is minimized.

### Radome measuring clamp

**M27.** The method according to any of the preceding method embodiments, wherein the at least one transmitting antenna (7T) and the at least one receiving antenna (7R) are attached on a radome measuring clamp (10) according to any of the preceding device embodiments.

**M28.** The method according to the preceding embodiment and with the features of embodiment D56,
wherein the method comprises rendering the radome measuring clamp (10) in at least one of the plurality of configurations prior to carrying out the rest of the method.

### Radome measurement

**M29.** The method according to any of the preceding method embodiments and with the features of embodiment M2, wherein step (c) comprises, determining at least one of
- attenuation of an electromagnetic wave traversing through the radome (15),
- difference between the attenuation of an electromagnetic caused when the radome (15) is positioned between the antennas (7T, 7R) and when the radome (15) is not positioned between the antennas (7T, 7R),
- time of flight (ToF) of the electromagnetic wave from the transmitting antenna (7T) to the receiving antenna (7R),
- difference between the ToF of the electromagnetic wave from the transmitting antenna (7T) to the receiving antenna (7R) when the radome (15) is positioned between the antennas (7T, 7R) and when the radome (15) is not positioned between the antennas (7T, 7R),
- phase shift caused of an electromagnetic wave cause by the radome (15),
- difference between the phase shift of an electromagnetic wave caused when the radome (15) is positioned between the antennas (7T, 7R) and when the radome (15) is not positioned between the antennas (7T, 7R),
- reflection of an electromagnetic wave caused by the radome (15),
- deflection of the main beam of the transmitting antenna (7T) due to the radome (15),
- increasing of the beam width of the transmitting antenna (7T) due to the radome (15),
- extension of sidelobes of the transmitting antenna (7T) due to the radome (15),
- the scattering parameters, or S-parameters, of the transmission of electromagnetic waves from the transmitting antenna (7T) to the receiving antenna (7R).

Below further device embodiments are discussed.

**D92.** The radome measuring clamp (10) according to any of the preceding device embodiments, wherein the radome measuring clamp is configured to facilitate carrying out the method according to any of the preceding method embodiments.

Below further system embodiments are discussed.

**S5.** The radome measuring system according to any of the preceding system embodiments, wherein the radome measuring system is configured to facilitate carrying out the method according to any of the preceding method embodiments.

### Brief description of the drawings

- Figs. 1a to 1d: illustrate different views of a first embodiment of a radome measuring clamp with two arms;
- Figs. 2a to 2d: illustrate different views of a second embodiment of a radome measuring clamp with a single arm;
- Figs. 3a to 3c: illustrate a radome measuring system comprising the radome measuring clamp with two arms mounted on an actuator device at different orientations;
- Figs. 4a to 4c: illustrate a radome measuring system comprising the radome measuring clamp with a single arm mounted on an actuator device at different orientations;
- Figs. 5a to 5c: illustrate a radome measuring system comprising the radome measuring clamp with a single arm mounted on an actuator device at different orientations, wherein further arm extensions are provided.

### Detailed description of the drawings

Generally referring to all the figures, the present invention relates to a radome measuring clamp (10), systems and methods for performing a radome measurement.

Throughout the description, the process of measuring a radome can be referred to as radome measurement. A radome measurement can comprise measuring electromagnetic, transmission and/or reflection properties of a radome. For example, during a radome measurement effects caused by a radome on an antenna (or radar or sensor) that the radome covers, can be measured, such as, attenuation and/or phase (e.g. a complex measurement) of an electromagnetic wave traversing through the radome, reflection of electromagnetic waves hitting the radome, deflection of the main beam of the antenna, increasing of the beam width of the antenna, extension of sidelobes of the antenna, etc. Alternatively or additionally, during a radome measurement the scattering parameters, or S-parameters, can be measured and/or calculated and/or inferred.

Alternatively or additionally the radome measurement can comprise measuring the phase of the electromagnetic wave traversing through the radome on multiple points of the radome. That is, electromagnetic waves are transmitted such that they can traverse different measuring points (or areas) of the radome and the phase of the electromagnetic waves can be measured. Further, the consistency (or stability) of the measured phases of the electromagnetic waves can be checked. That is, it can be measured (or calculated or observed) if and/or how much the measured phases of the electromagnetic waves traversing different parts or measuring points of the radome differ from each other. The phase measurements, particularly phase measurements of electromagnetic waves traversing through different measuring points of the radome, can facilitate inferring the effect that the radome can have on angle measurements (i.e. detection of angle of arrival) of the radar sensors intended to be covered by the radome. For example, if the phase measurements imply that the phase is stable from point to point of the radome or that the phase changes on different measuring points of the radome are less than a threshold value, then it can be inferred that the effect of the radome on the detection of the direction of arrival by the radar sensor is tolerable.

The present invention is directed towards facilitating and improving the process of measuring a radome.

In a first aspect, the present invention provides a radome measuring clamp (10). The radome measuring clamp (10) can provide an improved structure for mounting at least two antennas therein (e.g. a transmission antenna and a receiving antenna) which can be used to measure the effects of a radome on an electromagnetic wave. More particularly, the radome measuring clamp (10) provides a clamp structure, wherein the antennas can be mounted such that they can face each other and such that a device under test (i.e. radome) can be positioned between the antennas.

To provide the clamp structure wherein antennas can be mounted, the radome measuring clamp (10) can comprise a base frame (4), at least one arm (3, 5) and two antenna heads (1). The clamp structure or clamp shape of the radome measuring clamp (10) can be provided by having two components of the radome measuring clamp (10) substantially parallel to each other and at a distance from each other and attached to a third component of the radome measuring clamp (10) at a substantially perpendicular angle. As such, the two components and the third component can be arranged in substantially U shape (i.e. clamp structure).

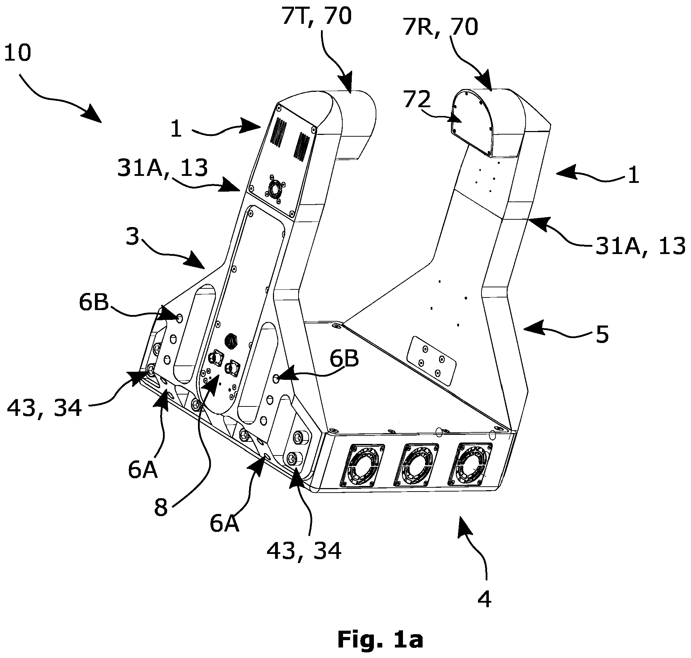

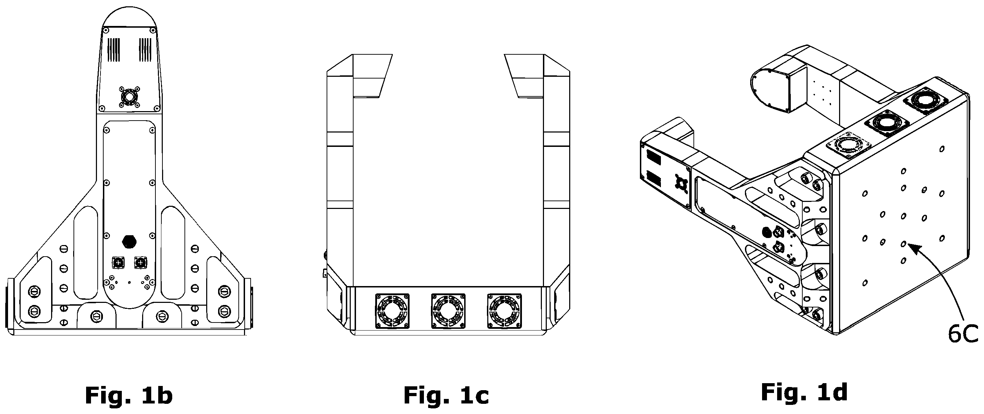

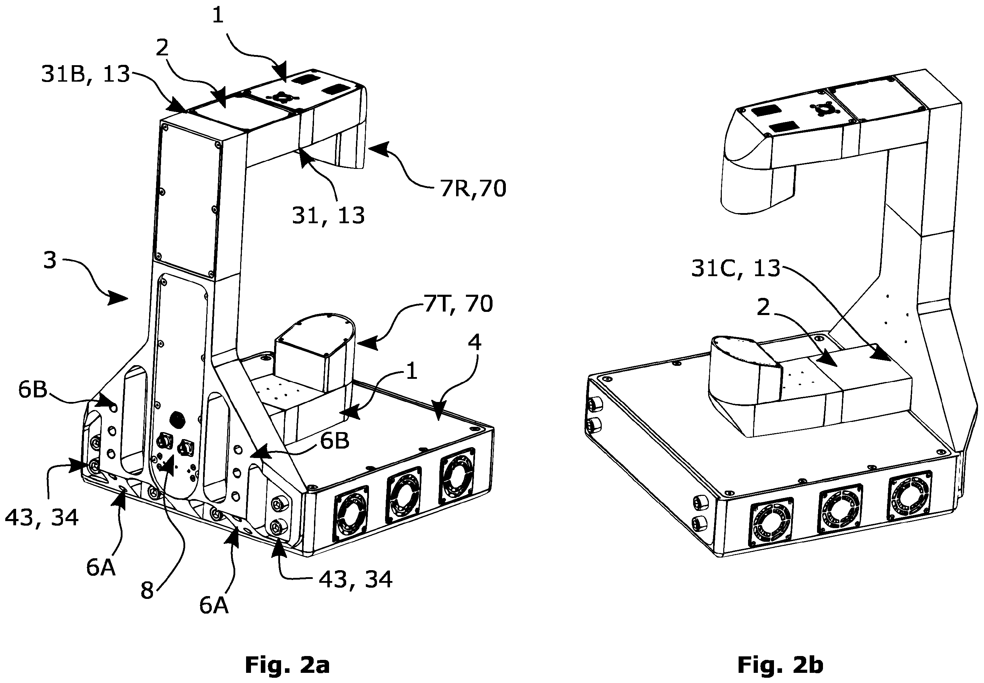

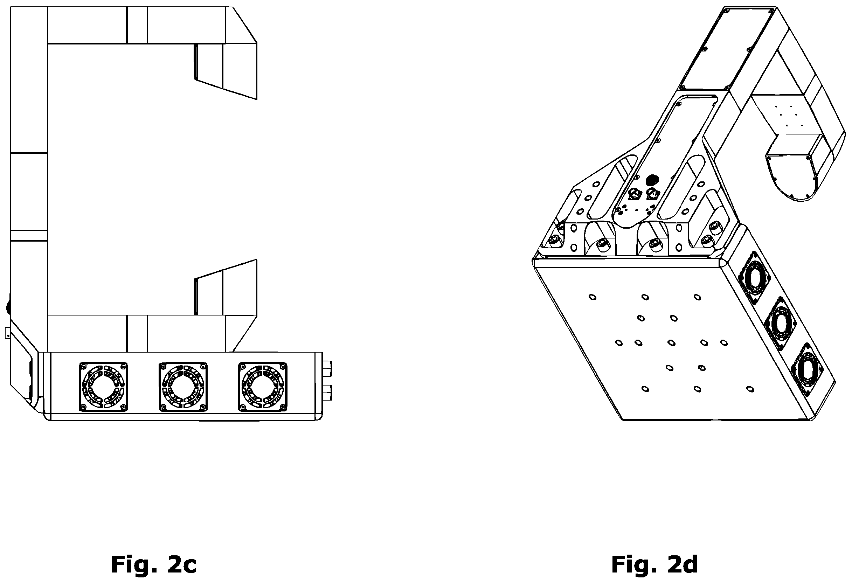

In the following, two preferred embodiments of the radome measuring clamp (10) will be discussed, which illustrate two alternative ways that the component of the radome measuring clamp (10) can be arranged such that a clamp structure can be created. More particularly, in a first embodiment illustrated in Figs. 1a to 1d (collectively referred to as Fig. 1), the clamp structure is formed by attaching a first arm (3) and a second arm (5) to the base frame (4). In a first embodiment illustrated in Figs. 2a to 2d (collectively referred to as Fig. 2), the clamp structure is formed by attaching two antenna heads (1) to the first arm (3). These embodiments will be discussed in more detail in the following.

Figs. 1a to 1d illustrate different views of a first embodiment of a radome measuring clamp (10).

The radome measuring clamp (10) can comprise a base frame (4). The base frame can comprise a substantially cuboid shape, wherein one of the dimensions can be smaller than the others. The base frame (4) can comprise an aluminum material.

Thus, the base frame (4) can comprise a top surface (i.e. top face) and a bottom surface (i.e. bottom face). Further, the base frame (4) can comprise 4 lateral surfaces (i.e. lateral faces). The bottom surface and the top surface of the base frame (4) can be substantially parallel to each other. To facilitate the description, of the radome measuring clamp (10), a horizontal plane (i.e. horizontal surface, horizontal surface, horizontal direction) is defined as being parallel to the top surface of the base frame (4) and a vertical plane (i.e. vertical surface, vertical surface, vertical direction) is defined as being perpendicular to the top surface of the base frame (4).

The base frame (4) can be configured to be releasably attached with at least one arm (3, 5). To facilitate this, the base frame (4) can comprise at least one base-arm mounting interface (43). The at least one base-arm mounting interface (43) can be provided on the lateral surface of the base frame (4).

In the embodiment of Fig. 1, the base frame (4) comprises two base-arm mounting interface (43), provided on opposite lateral surfaces of the base frame (4). For example, the base-arm mounting interface (43) can be provided on a surface of the base frame by drilling threaded holes therein. The threaded holes can be drilled in pre-defined relative positioned between each other.

Furthermore, the radome measuring clamp (10) can comprise a first arm (3) and a second arm (5), each releasably attached to the base frame (4). The arms (3, 5) can protrude substantially perpendicular with the top surface of the base frame (4). The two arms (3, 5) and the base frame (4) can be arranged in a U-shape, thus forming the clamp structure.

The first arm (3) and the second arm (5) can comprise an arm-base mounting interface (34). The arm-base mounting interface (34) can be provided near the ends of the arms (3, 5) such that the majority of the length of the arms extends in one side of the arm-base mounting interface (34). For example, the arms (3, 5) can be attached to the base frame (4) such that one of the ends of the arms (3, 5) can be aligned with the bottom surface of the base frame (4). Moreover, the arm-base mounting interface (34) can be compatible with the base frame (4). For example, the arm-base mounting interface (34) can be provided by drilling one or more holes through the arms (3, 5), wherein the holes of the arm can be aligned with holes of the base-arm mounting interface (43). This way, the arms (3, 5) and the base frame (4) can be attached by screwing at least one threaded structure (e.g. screw) through the holes of the arm-base mounting interface (34) into base-arm mounting interface (43). However, it will be understood that this is only exemplary.

Further, the radome measuring clamp (10) can comprise two antenna heads (1). Each of the antenna heads (1) can be releasably attached to a respective one of the first arm (3) and the second arm (5). The antenna heads (1) can be connected such that they are in a vertical position. That is, the antenna heads (1) can comprise a longitudinal direction that can be perpendicular to the top surface of the base frame (4). To facilitate this each of the arms (3, 5) can comprise a respective antenna head mounting interface (31). More particularly, each arm (3, 5) can comprise a first antenna head mounting interface (31A) which can allow the respective antenna head (1) to be attached therein, such that the antenna head (1) can comprise the same longitudinal direction with the respective arm (3, 5). Similarly, the antenna heads (1) can comprise a respective arm mounting interface (13). The arm mounting interface (13) can be compatible with the antenna head mounting interface of the arms (3, 5).

In some embodiments, the radome measuring clamp (10) can be configured such that the length of the arms (3, 5) can be extended. Thus, the radome measuring clamp (10) can further comprise an arm extension (2). The arm extension (2) can be provided between the arms (3, 5) and the respective antenna heads (1), thus increasing the distance between the arms (3, 5) and the respective antenna heads (1).

For example, the arm extension (2) can comprise an antenna head mounting interface (31) and an arm mounting interface (13). Thus, the arm extension (2) can be connected with the antenna head (1) and with the arm (3, 5).

The radome measuring clamp (10) can further comprise at least one electronic interface (8). The at least one electronic interface (8) can be provided on the first arm (3) and/or on the base frame (4). The at least one electronic interface (8) can be configured to facilitate connecting at least one power cable, at least one ethernet cable, at least one coaxial cable or any combination thereof to the radome measuring clamp (10). It will be understood that other cables and/or data connection means can be provided by the at least one electronic interface (8).

Further, the radome measuring clamp can comprise a first antenna and a second antenna, each attached, preferably releasably, to a respective antenna head (1). The first antenna and the second antenna can be attached to the respective antenna head (1) such that their respective boresights are substantially parallel to the top surface of the base frame (4), i.e. the boresights are in a horizontal direction with respect to the base frame).

The first antenna can be a transmission antenna (7T), which can interchangeably be referred to as a transmitting antenna (7T), and the second antenna can be a receiving antenna (7R). Alternatively, the first antenna and the second antenna can be transceivers.

In all of the figures, the transmission antenna (7T) and the receiving antenna (7R) are depicted encapsulated in a respective antenna housing 70. The antenna housing (70) can be configures to encapsulate an antenna (7T, 7R) from all sides. The antenna housing (70) can be advantageous as it can protect the antennas (7T, 7R). Moreover, the antenna housing (70) can be reduced to minimize reflections.

More particularly, on a back side (not visible) of the antenna housing (70) - wherein the back side refers to the surface of the antenna housing (70) that contacts the antenna head (1), when attached to the antenna head (1) - the antenna housing (70) can comprise a coating material configured to absorb electromagnetic waves. More particularly, the coating material can be configured to minimize the amount of energy reflected by the coating material when an electromagnetic wave is incident therein. The coating material can, for example, be a radio-frequency absorber foam material.

Furthermore, on a front side (72) the antenna housing (70) can comprise an inclined surface (72). The inclined surface (72) can be configured to minimize reflections. The inclined surface (72) can be provided in front of the respective antenna (7T, 7R). Thus, the inclined surface (72) intercept an electromagnetic wave transmitted from the transmitting antenna (7T) or received by the receiving antenna (7R). The inclined surface (72) can be provided inclined (i.e. not perpendicular) with respect to the direction of transmission/reception of the antenna (7T, 7R) it covers. As such, reflections are not parallel with the direction of transmission/reception of the respective antenna (7T, 7R). Moreover, this reduces the likelihood of a standing wave being created between the front side (72) and the back side of the antenna housing (70).

In addition, the thickness of the front side (72) can be adjusted such that destructive interference can be created between the reflections, hence reducing the amplitude of the reflections. More particularly, reflections are created when a first medium interfaces with a second medium - in this case when air interfaces with the surface of front side (72). There are two of such interfaces: from air to front side (72) and from the front side (72) to air, i.e. corresponding to the two surfaces of the front side (72), one facing towards the antenna and the other facing away from the antenna. Thus, a first set of reflections is created by the first interface and a second set of reflections is created by the second interface. By adjusting the distance between these two interfaces, i.e. by adjusting the thickness of the front side (72) the difference between the phase of the first set of reflections and the phase of the second set of reflections, when these two sets of reflections interfere with each other can be adjusted. Preferably, the thickness can be adjusted such that the first set of reflections is out of phase with the second set of reflections when they interfere, hence nullifying each other. This can further decrease the amount of reflections.

Typically, the thickness of the front side (72) can be proportional to the wavelength of the electromagnetic wave incident on the front side (72). Moreover, the thickness of the front side (72) also depends on the material of the front side (e.g. on the permittivity of the material of the front side 72). The front side (72) can comprise a plastic material, such as, polyamide (PA) or polyethylene terephthalate (PET). For example, for creating destructive interference of reflections generated when a signal with a frequency of 77 GHz is incident on the front side (72), the front side (72) can be configured with a thickness of approximately 1.6 mm.

Reducing reflections can lead to more accurate measurement, as less interference due to reflections is present.

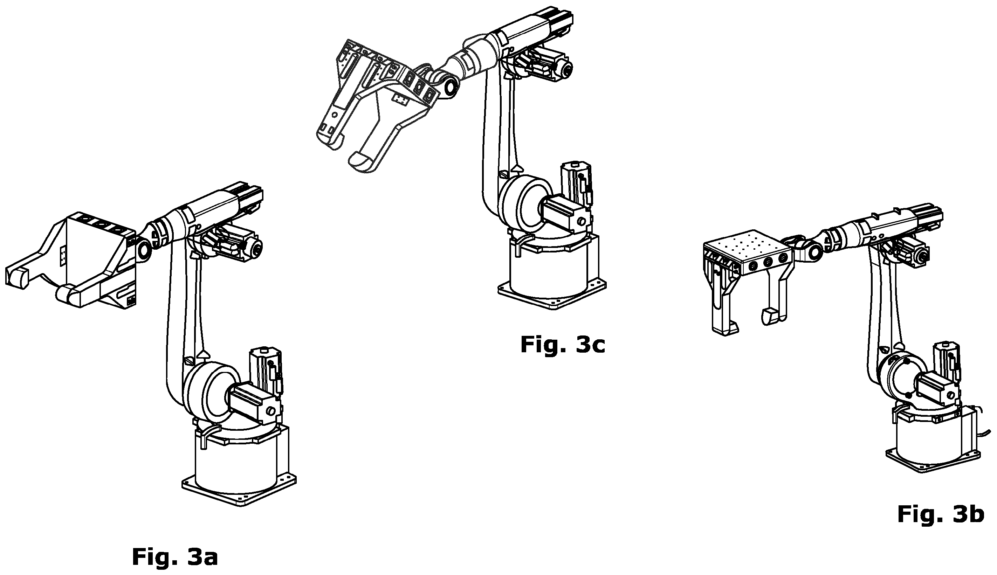

Further, the radome measuring clamp (10) can comprise at least one actuator mounting interface (6) configured to facilitate attaching, preferably releasably, the radome measuring clamp (10) to a handling device. This is illustrated in Figs. 3a to 3c.

More particularly, the radome measuring clamp (10) can comprise an actuator mounting interface (6C), which can be provided on the bottom surface of the radome measuring clamp (10), visible on Fig. 1d. The radome measuring clamp (10) mounted on a handling device using the actuator mounting interface (6C) is illustrated in Fig. 3a.

Alternatively or additionally, the radome measuring clamp (10) can comprise an actuator mounting interface (6A), which can be provided on an outer lateral surface of the first arm (3) and/or of the second arm (5). The radome measuring clamp (10) mounted on a handling device using the actuator mounting interface (6B) is illustrated in Fig. 3b.

Alternatively or additionally, the radome measuring clamp (10) can comprise an actuator mounting interface (6A), which can be provided on a sloped surface of the first arm (3) and/or of the second arm (5). The sloped surface can form an acute angle of 20 to 60 degrees, such as 45 degrees, with the top surface of the base frame (4). The radome measuring clamp (10) mounted on a handling device using the actuator mounting interface (6B) is illustrated in Fig. 3c.

Figs. 2a to 2d illustrates an alternative embodiment of the radome measuring clamp (10) comprising only one arm (3). The clamp structure, in this embodiment, can be created by the two antenna heads (1) and the first arm (3). It will be noted that the first arm (3) is arbitrarily chosen. Similarly, the second arm (5) can be used instead of the first arm (3). Generally, the first arm (3) and the second arm (5) can be identical. More particularly, the first arm (3) and the second arm (5) can comprise a similar or identical shape or structure.

The first arm (3) can be configured such that two antenna heads (1) can be mounted therein, such that the antenna heads extend horizontally. That is, in such embodiments, the boresights of the antennas can be perpendicular to the top surface of the base frame (4). To facilitate this, the first arm (3) can comprise a second antenna head mounting interface (31B) and a third antenna head mounting interface (31C).

Figs. 2a to 2d further illustrate two arm extension 2, each provided between the first arm and antenna heads (1), respectively.

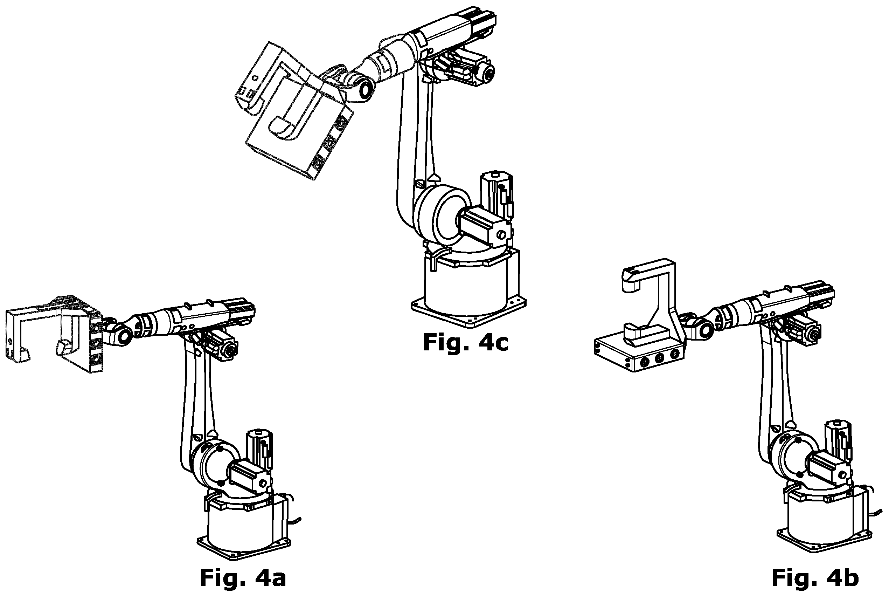

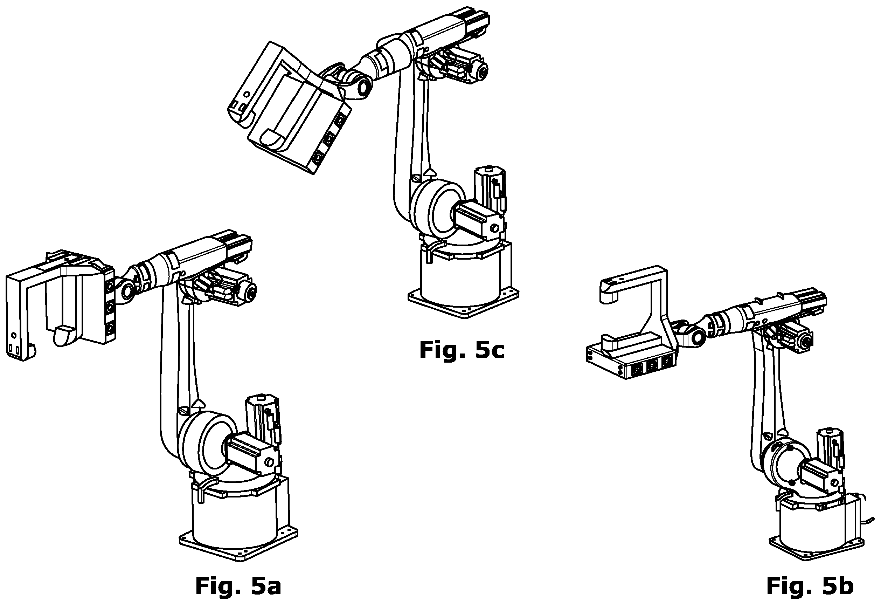

Similarly, the radome measuring clamp (10) illustrated in Fig. 2a to 2d can comprise one or more actuator mounting interfaces (6). Figs. 4a to 4c illustrate the radome measuring clamp (10) of Figs. 2a to 2d mounted on an actuator device at different orientations. Figs. 5a to 5c illustrate the radome measuring clamp (10) of Figs. 2a to 2d mounted on an actuator device at different orientations, wherein longer or multiple arm extension (2) are used to further increase the distance between the first arm (3) and the antenna heads (1).

Whenever a relative term, such as "about", "substantially" or "approximately" is used in this specification, such a term should also be construed to also include the exact term. That is, e.g., "substantially straight" should be construed to also include "(exactly) straight".

It should also be understood that whenever reference is made to an element this does not exclude a plurality of said elements. For example, if something is said to comprise an element it may comprise a single element but also a plurality of elements.

Whenever steps were recited in the above or also in the appended claims, it should be noted that the order in which the steps are recited in this text may be accidental. That is, unless otherwise specified or unless clear to the skilled person, the order in which steps are recited may be accidental. That is, when the present document states, e.g., that a method comprises steps (A) and (B), this does not necessarily mean that step (A) precedes step (B), but it is also possible that step (A) is performed (at least partly) simultaneously with step (B) or that step (B) precedes step (A). Furthermore, when a step (X) is said to precede another step (Z), this does not imply that there is no step between steps (X) and (Z). That is, step (X) preceding step (Z) encompasses the situation that step (X) is performed directly before step (Z), but also the situation that (X) is performed before one or more steps (Y1), ..., followed by step (Z). Corresponding considerations apply when terms like "after" or "before" are used.

While in the above, a preferred embodiment has been described with reference to the accompanying drawings, the skilled person will understand that this embodiment was provided for illustrative purpose only and should by no means be construed to limit the scope of the present invention, which is defined by the claims.

Furthermore, reference numbers and letters appearing between parentheses in the claims, identifying features described in the embodiments and illustrated in the accompanying drawings, are provided as an aid to the reader as an exemplification of the matter claimed. The inclusion of such reference numbers and letters is not to be interpreted as placing any limitations on the scope of the claims.

## Claims

1. A radome measuring clamp (10) configured to facilitate performing a radome measurement, the radome measuring clamp (10) comprising
a base frame (4);
a first arm (3) attached to the base frame (4);
two antenna heads (1), each configured for attaching at least one antenna therein;
**characterized in that**
the radome measuring clamp (10) comprises an arm extension (2) and wherein the arm extension (2) is configured to facilitate extending the length of the first arm (3);
wherein the arm extension (2) is configured to be releasably attached with the first arm (3) and with one of the at least two antenna heads (1) and between the first arm (3) and the one of the at least two antenna heads (1) for increasing a distance between the first arm (3) and the one of the at least two antenna heads (1).

2. The radome measuring clamp (10) according to the preceding claim, wherein the base frame (4) and the first arm (3) are configured to be releasably attached to each other.

3. The radome measuring clamp (10) according to any of the preceding claims, wherein the first arm (3) is configured for releasably attaching at least one of the two antenna heads (1) therein.

4. The radome measuring clamp (10) according to any of the preceding claims, wherein the arm extension (2) is further configured such that two arm extensions (2) are releasably attachable with each other.

5. The radome measuring clamp (10) according to the preceding claim, wherein
wherein at least one further arm extension (2') is configured to be releasably attached between first arm (3) and the arm extension (2) for further increasing a distance between the first arm (3) and the one of the at least two antenna heads (1) and/or
wherein at least one further arm extension (2') is configured to be releasably attached between the one of the at least two antenna heads (1) and the arm extension (2) for further increasing a distance between the first arm (3) and the one of the at least two antenna heads (1).

6. The radome measuring clamp (10) according to any of the preceding claims,
wherein the radome measuring clamp (10) comprises a second arm (5) and
wherein the base frame (4) and the second arm (5) are configured to be releasably attached to each other and
wherein the first arm (3) and the second arm (5) protrude along the same direction from the base frame (4).

7. The radome measuring clamp (10) according to the preceding claim, wherein each of the antenna heads (1) is configured to be releasably attached on a respective one of the first arm (3) and second arm (5).

8. The radome measuring clamp (10) according to any of the 2 preceding claims, wherein the radome measuring clamp (10) comprises a respective arm extension (2) for the first arm (3) and the second arm (5).

9. The radome measuring clamp (10) according to any of the preceding claims, wherein the first arm (3) is configured for releasably attaching the two antenna heads (1) therein.

10. The radome measuring clamp (10) according to any of the preceding claims, wherein the radome measuring clamp (10) is configured to be attached to a handling device,
wherein the handling device is configured to position the radome measuring clamp (10) in a plurality of positions, such as in any position, within a reachable space of the handling device.

11. The radome measuring clamp (10) according to the preceding claim, wherein the radome measuring clamp (10) comprises a plurality of actuator mount interfaces (6),
wherein each actuator mount interface (6) is configured to facilitate mounting the radome measuring clamp (10) to the handling device in a respective orientation of the radome measuring clamp (10) relative to the handling device.

12. The radome measuring clamp (10) according to any of the preceding claims and with the features of claims 6 and 9,
wherein the radome measuring clamp (10) is configured to be rendered in a plurality of configurations,
wherein the radome measuring clamp (10) is configured to be rendered in a first configuration, by attaching the second arm (5) to the base frame (4),
wherein the radome measuring clamp (10) is configured to be rendered in a second configuration, by attaching the two antenna heads (1) to the first arm (3) and
wherein the radome measuring clamp (10) is configured to be rendered from the first configuration to the second configuration and from the second configuration to the first configuration.

13. A radome measuring system comprising
a radome measuring clamp (10) according to any of the preceding claims;
a handling device configured to position the radome measuring clamp (10) in a plurality of positions, such as in any position, within a reachable space of the handling device.

14. A method of measuring the effects of a radome on electromagnetic waves traversing through the radome, the method comprising the steps of:
(a) positioning a radome (15) between at least one transmitting antenna (7T) and at least one receiving antenna (7R);
(b) performing a radome measurement, wherein performing a radome measurement comprises:
(i) triggering the at least one transmitting antenna (7T) to radiate electromagnetic waves,
(ii) receiving the transmitted electromagnetic waves in step (i) by the at least one receiving antenna (7R),
(iii)measuring at least one difference between the transmitted and received electromagnetic waves
**characterized in that** the at least one transmitting antenna (7T) and the at least one receiving antenna (7R) are attached on a radome measuring clamp (10) according to any of the claims 1 to 12.

15. The method according to the preceding claim, wherein the method further comprises
- performing a prior referencing with an empty measurement by additionally performing step (b) prior to step (a),
- step (d) comprising positioning the radome (15) such that the radome (15) is not between the at least one transmitting antenna (7T) and the at least one receiving antenna (7R), wherein step (d) is performed after steps (a) and (b),
- performing a post referencing with an empty measurement by additionally performing step (b) after step (d),
- comparing the prior referencing with an empty measurement with the post referencing with an empty measurement,
- determining based on the comparison a validity of the radome measurement.

## Patentansprüche

1. Halterung (10) zur Messung von Radomen, die dazu konfiguriert ist, die Durchführung einer Radommessung zu erleichtern, wobei die Halterung (10) zur Messung von Radomen Folgendes umfasst:
einem Grundrahmen (4);
einen ersten Arm (3), der an dem Grundrahmen (4) befestigt ist;
zwei Antennenköpfe (1), die jeweils zur Befestigung mindestens einer Antenne darin konfiguriert sind;
**dadurch gekennzeichnet, dass** die Halterung (10) zur Messung von Radomen eine Armverlängerung (2) umfasst und wobei die Armverlängerung (2) dazu konfiguriert ist, die Verlängerung des ersten Arms (3) zu erleichtern;
wobei die Armverlängerung (2) dazu konfiguriert ist, lösbar mit dem ersten Arm (3) und mit einem der mindestens zwei Antennenköpfe (1) und zwischen dem ersten Arm (3) und dem einen der mindestens zwei Antennenköpfe (1) befestigt zu werden, um einen Abstand zwischen dem ersten Arm (3) und dem einen der mindestens zwei Antennenköpfe (1) zu vergrößern.

2. Halterung (10) zur Messung von Radomen nach dem vorhergehenden Anspruch, wobei der Grundrahmen (4) und der erste Arm (3) dazu konfiguriert sind, lösbar aneinander befestigt zu werden.

3. Halterung (10) zur Messung von Radomen nach einem der vorhergehenden Ansprüche, wobei der erste Arm (3) dazu konfiguriert ist, mindestens einen der beiden Antennenköpfe (1) lösbar darin zu befestigen.

4. Halterung (10) zur Messung von Radomen nach einem der vorhergehenden Ansprüche, wobei die Armverlängerung (2) ferner so konfiguriert ist, dass zwei Armverlängerungen (2) lösbar miteinander verbunden werden können.

5. Halterung (10) zur Messung von Radomen nach dem vorhergehenden Anspruch,
wobei mindestens eine weitere Armverlängerung (2') dazu konfiguriert ist, lösbar zwischen dem ersten Arm (3) und der Armverlängerung (2) befestigt zu werden, um einen Abstand zwischen dem ersten Arm (3) und dem einen der mindestens zwei Antennenköpfe (1) weiter zu vergrößern und/oder
wobei mindestens eine weitere Armverlängerung (2') dazu konfiguriert ist,
lösbar zwischen dem einen der mindestens zwei Antennenköpfe (1) und der Armverlängerung (2) befestigt zu werden, um den Abstand zwischen dem ersten Arm (3) und dem einen der mindestens zwei Antennenköpfe (1) weiter zu vergrößern.

6. Halterung (10) zur Messung von Radomen nach einem der vorhergehenden Ansprüche,
wobei die Halterung (10) zur Messung von Radomen einen zweiten Arm (5) umfasst und
wobei der Grundrahmen (4) und der zweite Arm (5) dazu konfiguriert sind, lösbar aneinander befestigt zu werden und
wobei der erste Arm (3) und der zweite Arm (5) entlang der gleichen Richtung von dem Grundrahmen (4) vorstehen.

7. Halterung (10) zur Messung von Radomen nach dem vorhergehenden Anspruch, wobei jeder der Antennenköpfe (1) dazu konfiguriert ist, lösbar an jeweils einem aus dem ersten Arm (3) und dem zweiten Arm (5) befestigt zu werden.

8. Halterung (10) zur Messung von Radomen nach einem der 2 vorhergehenden Ansprüche, wobei die Halterung (10) zur Messung von Radomen jeweils eine Armverlängerung (2) für den ersten Arm (3) und den zweiten Arm (5) umfasst.

9. Halterung (10) zur Messung von Radomen nach einem der vorhergehenden Ansprüche, wobei der erste Arm (3) dazu konfiguriert ist, die beiden Antennenköpfe (1) lösbar darin zu befestigen.

10. Halterung (10) zur Messung von Radomen nach einem der vorhergehenden Ansprüche, wobei die Halterung (10) zur Messung von Radomen dazu konfiguriert ist, an einer Handhabungsvorrichtung befestigt zu werden,
wobei die Handhabungsvorrichtung dazu konfiguriert ist, die Halterung (10) zur Messung von Radomen in einer Vielzahl von Positionen, wie beispielsweise in einer beliebigen Position, innerhalb eines erreichbaren Raums der Handhabungsvorrichtung zu positionieren.

11. Halterung (10) zur Messung von Radomen nach dem vorhergehenden Anspruch, wobei die Halterung (10) zur Messung von Radomen eine Vielzahl von Aktuatormontageschnittstellen (6) umfasst,
wobei jede Aktuatormontageschnittstelle (6) dazu konfiguriert ist, die Montage der Halterung (10) zur Messung von Radomen an der Handhabungsvorrichtung in einer jeweiligen Ausrichtung der Halterung (10) zur Messung von Radomen relativ zu der Handhabungsvorrichtung zu erleichtern.

12. Halterung (10) zur Messung von Radomen nach einem der vorhergehenden Ansprüche und mit den Merkmalen der Ansprüche 6 und 9,
wobei die Halterung (10) zur Messung von Radomen dazu konfiguriert ist, in eine Vielzahl von Konfigurationen gebracht zu werden,
wobei die Halterung (10) zur Messung von Radomen dazu konfiguriert ist, in eine erste Konfiguration gebracht zu werden, indem der zweite Arm (5) am Grundrahmen (4) befestigt wird,
wobei die Halterung (10) zur Messung von Radomen dazu konfiguriert ist, in eine zweite Konfiguration gebracht zu werden, indem die beiden Antennenköpfe (1) an dem ersten Arm (3) befestigt werden und
wobei die Halterung (10) zur Messung von Radomen dazu konfiguriert ist, von der ersten Konfiguration in die zweite Konfiguration und von der zweiten Konfiguration in die erste Konfiguration gebracht zu werden.

13. System zur Messung von Radomen, das Folgendes umfasst:
eine Halterung (10) zur Messung von Radomen nach einem der vorhergehenden Ansprüche;
eine Handhabungsvorrichtung, die dazu konfiguriert ist, die Halterung (10) zur Messung von Radomen in einer Vielzahl von Positionen, wie beispielsweise in einer beliebigen Position, innerhalb eines erreichbaren Raums der Handhabungsvorrichtung zu positionieren.

14. Verfahren zur Messung der Auswirkungen eines Radoms auf elektromagnetische Wellen, die das Radom durchlaufen, wobei das Verfahren die folgenden Schritte umfasst:
(a) Positionieren eines Radoms (15) zwischen mindestens einer Sendeantenne (7T) und mindestens einer Empfangsantenne (7R);
(b) Durchführen einer Radommessung, wobei das Durchführen einer Radommessung umfasst:
(i) Aktivieren der mindestens einen Sendeantenne (7T) zum Abstrahlen elektromagnetischer Wellen,
(ii) Empfangen der in Schritt (i) gesendeten elektromagnetischen Wellen durch die mindestens eine Empfangsantenne (7R),
(iii) Messen mindestens einer Differenz zwischen den gesendeten und empfangenen elektromagnetischen Wellen,
**dadurch gekennzeichnet, dass** die mindestens eine Sendeantenne (7T) und die mindestens eine Empfangsantenne (7R) an einer Halterung (10) zur Messung von Radomen nach einem der Ansprüche 1 bis 12 befestigt sind.

15. Verfahren nach dem vorhergehenden Anspruch, wobei das Verfahren ferner Folgendes umfasst:
- Durchführen einer Vorreferenzierung mit einer Leermessung durch zusätzliches Durchführen von Schritt (b) vor Schritt (a),
- Schritt (d), der das Positionieren des Radoms (15) umfasst, so dass sich das Radom (15) nicht zwischen der mindestens einen Sendeantenne (7T) und der mindestens einen Empfangsantenne (7R) befindet, wobei Schritt (d) nach den Schritten (a) und (b) durchgeführt wird,
- Durchführen einer Nachreferenzierung mit einer Leermessung durch zusätzliches Durchführen von Schritt (b) nach Schritt (d),
- Vergleichen der Vorreferenzierung mit einer Leermessung mit der Nachreferenzierung mit einer Leermessung,
- Bestimmen der Gültigkeit der Radommessung basierend auf dem Vergleich.

## Revendications

1. - Pince de mesure de radôme (10) configurée pour faciliter la réalisation d'une mesure de radôme, la pince de mesure de radôme (10) comprenant :
un châssis de base (4) ;
un premier bras (3) fixé au châssis de base (4) ;
deux têtes d'antenne (1), chacune étant configurée pour fixer au moins une antenne à l'intérieur de celle-ci ;
**caractérisée par le fait que** la pince de mesure de radôme (10) comprend une extension de bras (2) et l'extension de bras (2) étant configurée pour faciliter l'extension de la longueur du premier bras (3) ;
l'extension de bras (2) étant configurée pour être fixée de manière libérable au premier bras (3) et à l'une des au moins deux têtes d'antenne (1) et entre le premier bras (3) et celle des au moins deux têtes d'antenne (1) pour augmenter une distance entre le premier bras (3) et celle des au moins deux têtes d'antenne (1).

2. - Pince de mesure de radôme (10) selon la revendication précédente, dans laquelle le châssis de base (4) et le premier bras (3) sont configurés pour être fixés l'un à l'autre de manière libérable.

3. - Pince de mesure de radôme (10) selon l'une quelconque des revendications précédentes, dans laquelle le premier bras (3) est configuré pour fixer de manière libérable au moins une des deux têtes d'antenne (1) à l'intérieur de celui-ci.

4. - Pince de mesure de radôme (10) selon l'une quelconque des revendications précédentes, dans laquelle l'extension de bras (2) est en outre configurée de telle sorte que deux extensions de bras (2) sont aptes à être fixées l'une à l'autre de manière libérable.

5. - Pince de mesure de radôme (10) selon la revendication précédente, dans laquelle
au moins une autre extension de bras (2') est configurée pour être fixée de manière libérable entre le premier bras (3) et l'extension de bras (2) pour augmenter davantage une distance entre le premier bras (3) et celle des au moins deux têtes d'antenne (1), et/ou
au moins une autre extension de bras (2') est configurée pour être fixée de manière libérable entre celle des au moins deux têtes d'antenne (1) et l'extension de bras (2) pour augmenter davantage une distance entre le premier bras (3) et celle des moins deux têtes d'antenne (1).

6. - Pince de mesure de radôme (10) selon l'une quelconque des revendications précédentes, dans laquelle
la pince de mesure de radôme (10) comprend un second bras (5), et
le châssis de base (4) et le second bras (5) sont configurés pour être fixés de manière libérable l'un à l'autre, et
le premier bras (3) et le second bras (5) font saillie selon la même direction à partir du châssis de base (4).

7. - Pince de mesure de radôme (10) selon la revendication précédente, dans laquelle chacune des têtes d'antenne (1) est configurée pour être fixée de manière libérable sur l'un respectif du premier bras (3) et du second bras (5).

8. - Pince de mesure de radôme (10) selon l'une quelconque des 2 revendications précédentes, dans laquelle la pince de mesure de radôme (10) comprend une extension de bras (2) respective pour le premier bras (3) et le second bras (5).

9. - Pince de mesure de radôme (10) selon l'une quelconque des revendications précédentes, dans laquelle le premier bras (3) est configuré pour fixer de manière libérable les deux têtes d'antenne (1) à l'intérieur de celui-ci.

10. - Pince de mesure de radôme (10) selon l'une quelconque des revendications précédentes, dans laquelle la pince de mesure de radôme (10) est configurée pour être fixée à un dispositif de manipulation,
le dispositif de manipulation étant configuré pour positionner la pince de mesure de radôme (10) dans une pluralité de positions, notamment dans n'importe quelle position, dans un espace accessible au dispositif de manipulation.

11. - Pince de mesure de radôme (10) selon la revendication précédente, dans laquelle la pince de mesure de radôme (10) comprend une pluralité d'interfaces de montage d'actionneur (6),
chaque interface de montage d'actionneur (6) étant configurée pour faciliter un montage de la pince de mesure de radôme (10) sur le dispositif de manipulation dans une orientation respective de la pince de mesure de radôme (10) par rapport au dispositif de manutention.

12. - Pince de mesure de radôme (10) selon l'une quelconque des revendications précédentes et présentant les caractéristiques des revendications 6 et 9, dans laquelle
la pince de mesure de radôme (10) est configurée pour être placée dans une pluralité de configurations,
la pince de mesure de radôme (10) est configurée pour être placée dans une première configuration, par fixation du second bras (5) au châssis de base (4),
la pince de mesure de radôme (10) est configurée pour être placée dans une deuxième configuration, par fixation des deux têtes d'antenne (1) au premier bras (3), et
la pince de mesure de radôme (10) est configurée pour être placée de la première configuration à la deuxième configuration et de la deuxième configuration à la première configuration.

13. - Système de mesure de radôme comprenant :
une pince de mesure de radôme (10) selon l'une quelconque des revendications précédentes ;
un dispositif de manipulation configuré pour positionner la pince de mesure de radôme (10) dans une pluralité de positions, notamment dans n'importe quelle position, dans un espace accessible au dispositif de manipulation.

14. - Procédé de mesure des effets d'un radôme sur des ondes électromagnétiques traversant le radôme, le procédé comprenant les étapes :
(a) positionner un radôme (15) entre au moins une antenne d'émission (7T) et au moins une antenne de réception (7R) ;
(b) effectuer une mesure de radôme, la réalisation d'une mesure de radôme comprenant :
(i) déclencher l'au moins une antenne d'émission (7T) pour rayonner des ondes électromagnétique,
(ii) recevoir les ondes électromagnétiques émises à l'étape (i) par l'au moins une antenne de réception (7R),
(iii) mesurer au moins une différence entre les ondes électromagnétiques émises et reçues
**caractérisé par le fait que** l'au moins une antenne d'émission (7T) et l'au moins une antenne de réception (7R) sont fixées sur une pince de mesure de radôme (10) selon l'une quelconque des revendications 1 à 12.

15. - Procédé selon la revendication précédente, le procédé comprenant en outre :
- effectuer un référencement antérieur avec une mesure vide en effectuant en plus l'étape (b) avant l'étape (a),
- l'étape (d) comprenant positionner le radôme (15) de telle sorte que le radôme (15) ne se trouve pas entre l'au moins une antenne d'émission (7T) et l'au moins une antenne de réception (7R), l'étape (d) étant réalisée après les étapes (a) et (b),
- effectuer un référencement postérieur avec une mesure vide en effectuant l'étape (b) après l'étape (d),
- comparer le référencement antérieur avec une mesure vide au référencement postérieur avec une mesure vide,
- déterminer, sur la base de la comparaison, une validité de la mesure de radôme.
